# EUROPEAN PATENT SPECIFICATION

(11) **EP 4 439 563 B1**
(45) Date of publication and mention of the grant of the patent: **19.08.2026**
(21) Application number: 23210878.7
(22) Date of filing: 20.11.2023
(51) Int. Cl.: G11C 16/14, G11C 16/16, G11C 16/34

(54) **NONVOLATILE MEMORY DEVICE AND METHOD OF CONTROLLING THE SAME**
NICHTFLÜCHTIGE SPEICHERVORRICHTUNG UND VERFAHREN ZUR STEUERUNG DAVON
DISPOSITIF DE MÉMOIRE NON VOLATILE ET SON PROCÉDÉ DE COMMANDE

(30) Priority: 30.03.2023 KR 20230042148
(43) Date of publication of application: 02.10.2024
(73) Proprietor: Samsung Electronics Co., Ltd., Suwon-si, Gyeonggi-do 16677 (KR)
(72) Inventor: SEOK, Junyeong, Suwon-si, Gyeonggi-do 16677 (KR); SHIN, Beomkyu, Suwon-si, Gyeonggi-do 16677 (KR); OH, Eunchu, Suwon-si, Gyeonggi-do 16677 (KR)
(74) Representative: Kuhnen & Wacker Patent- und Rechtsanwaltsbüro PartG mbB

(56) References cited:
- US-A1- 2010 002 513
- US-A1- 2020 243 144
- US-A1- 2021 335 434

## Description

### BACKGROUND

Semiconductor memory devices for storing data may be classified into volatile memory devices and nonvolatile memory devices. Volatile memory devices, such as dynamic random access memory (DRAM) devices, are typically configured to store data by charging or discharging capacitors in memory cells, and lose the stored data when power is off. Nonvolatile memory devices, such as flash memory devices, may maintain stored data even though power is off. Volatile memory devices are widely used as main memories of various apparatuses, while nonvolatile memory devices are widely used for storing program codes and/or data in various electronic devices, such as computers, mobile devices, etc.

Recently, nonvolatile memory devices including three-dimensional structures such as vertical NAND memory devices have been developed to increase the degree of device integration and memory capacity of the nonvolatile memory devices. Along with increases in the integration degree and memory capacity, the unit capacity of the erase operation in the nonvolatile memory device increases. A threshold voltage of erased cells connected to a wordline may increase due to disturbance according to a program operation and a read operation of another wordline belonging to the same memory block. An increase in the threshold voltage of these erased cells degrades the reliability of the nonvolatile memory device.

US 2010/002513 A1 discloses the following: A non-volatile storage system can selectively perform one or more erase operations on a subset of non-volatile storage elements that are connected to a common word line (or other type of control line) without intentionally erasing other non-volatile storage elements that are connected to the common word line (or other type of control line) but not in the subset.

### SUMMARY

The invention is defined by the appended claims.

Various implementations of the present disclosure are directed to nonvolatile memory devices and methods of controlling a nonvolatile memory device that can efficiently enhance reliability of the nonvolatile memory devices.

According to some implementations, a memory block is divided into a plurality of sub blocks including a first sub block and a second sub block that are disposed in a vertical direction where the memory block includes a plurality of cell strings and each cell string includes a plurality of memory cells that are disposed in the vertical direction. A method of controlling a nonvolatile memory device includes a normal erase operation that is performed independently with respect to each of the plurality of sub blocks of the memory block. A disturbance verification read operation with respect to the first sub block is performed to determine whether a threshold voltage of memory cells connected to a wordline in an erased state of the first sub block is increased higher than a reference level by a program operation and a read operation with respect to the second sub block. A post erase operation is selectively performed based on a result of the disturbance verification read operation to decrease the threshold voltage of memory cells in the erased state of the first sub block.

According to some implementations, a nonvolatile memory device includes a memory cell array and a controller. The memory cell array includes a memory block divided into a plurality of sub blocks including a first sub block and a second sub block that are disposed in a vertical direction where the memory block includes a plurality of cell strings and each cell string includes a plurality of memory cells that are disposed in the vertical direction. The control circuit performs a normal erase operation independently with respect to each of the plurality of sub blocks, performs a disturbance verification read operation with respect to the first sub block to determine whether a threshold voltage of memory cells connected to a wordline in an erased state of the first sub block is increased higher than a reference level by a program operation and a read operation with respect to the second sub block, and selectively performs a post erase operation based on a result of the disturbance verification read operation to decrease the threshold voltage of memory cells in the erased state of the first

According to some implementations, a nonvolatile memory device includes a plurality of first bonding metal patterns disposed in a cell region, a plurality of second bonding metal patterns disposed in a peripheral region disposed under the cell region, wherein the peripheral region is vertically coupled to the cell region by the plurality of first bonding metal patterns and the plurality of second bonding metal patterns, a memory cell array and a control circuit. The memory cell array is disposed in the cell region and includes a memory block. The memory block is divided into a plurality of sub blocks including a first sub block and a second sub block that are disposed in a vertical direction where the memory block includes a plurality of cell strings and each cell string includes a plurality of memory cells that are disposed in the vertical direction. The control circuit is disposed in the peripheral region. The control circuit performs a normal erase operation independently with respect to each of the plurality of sub blocks, performs a disturbance verification read operation with respect to the first sub block to determine whether a threshold voltage of memory cells connected to a wordline in an erased state of the first sub block is increased higher than a reference level by a program operation and a read operation with respect to the second sub block, and selectively performs a post erase operation based on a result of the disturbance verification read operation to decrease the threshold voltage of memory cells in the erased state of the first sub block.

The nonvolatile memory devices and the methods of controlling the nonvolatile memory device according to some implementations may reduce unnecessary erasure of memory cells and increase the lifespan of the nonvolatile memory device by grouping the memory block into the sub blocks to manage the erase operation.

The nonvolatile memory devices and the methods of controlling the nonvolatile memory device according to some implementations may secure the reliability of the nonvolatile memory device and enhance the performance of the nonvolatile memory device by reducing the disturbance caused in the victim sub block by the aggressor sub block through the post erase operation.

### BRIEF DESCRIPTION OF THE DRAWINGS

Example implementations of the present disclosure will be more clearly understood from the following detailed description taken in conjunction with the accompanying drawings.
FIG. 1 is a block diagram illustrating a storage system according to some implementations.
FIG. 2 is a flowchart illustrating a method of controlling a nonvolatile memory device according to some implementations.
FIG. 3 is a diagram illustrating state change of memory cells in a method of controlling a nonvolatile memory device according to some implementations.
FIG. 4 is a diagram illustrating an example of state-bit mapping information indicating mapping relationship between states in FIG. 3 and bit values.
FIG. 5 is a block diagram illustrating a storage controller according to some implementations.
FIG. 6 is a block diagram illustrating a nonvolatile memory device according to some implementations.
FIG. 7 is a block diagram illustrating a memory cell array included in the nonvolatile memory device of FIG. 6.
FIG. 8 is a circuit diagram illustrating an equivalent circuit of a memory block included in the memory cell array of FIG. 7.
FIG. 9 is a circuit diagram illustrating an erase bias condition of a nonvolatile memory device according to some implementations.
FIG. 10 is a circuit diagram illustrating a read bias condition of a nonvolatile memory device according to some implementations.
FIG. 11 is a circuit diagram illustrating a program bias condition of a nonvolatile memory device according to some implementations.
FIG. 12 is a diagram illustrating voltages in a post erase operation and a normal erase operation according to some implementations.
FIG. 13 is a diagram illustrating an erase operation according to an incremental step pulse erasing (ISPE) scheme.
FIG. 14 is a diagram illustrating voltages in a post erase operation and a normal erase operation according to an ISPE scheme according to some implementations.
FIG. 15 is a diagram illustrating an example of block information in a method of controlling a nonvolatile memory device according to some implementations.
FIG. 16 is a flowchart illustrating a method of controlling a nonvolatile memory device according to some implementations.
FIG. 17 is a diagram illustrating a timing of a post erase operation in a method of controlling a nonvolatile memory device according to some implementations.
FIG. 18 is a flowchart illustrating a method of controlling a nonvolatile memory device according to some implementations.
FIG. 19 is a diagram illustrating a comparative example and a nonvolatile memory device according to some implementations.
FIG. 20 is a plan view of a nonvolatile memory device according to some implementations.
FIG. 21 is a cross-sectional diagram illustrating a vertical structure of the nonvolatile memory device of FIG. 20.
FIG. 22 is an enlarged sectional view illustrating an end portion of an erase channel structure included in the nonvolatile memory device of FIG. 21.
FIG. 23 is a diagram illustrating an example structure of a cell string included in a nonvolatile memory device according to some implementations.
FIG. 24 is a perspective view illustrating a memory block included in a nonvolatile memory device according to some implementations.
FIG. 25 is a cross-sectional view for describing some implementations of a boundary layer included in the memory block of FIG. 24.
FIGS. 26A through 30B are diagrams illustrating a method of performing an erase operation in a nonvolatile memory device according to some implementations.
FIGS. 31A and 31B are cross-sectional views illustrating a memory block included in a nonvolatile memory device according to some implementations.

### DETAILED DESCRIPTION

Various example implementations will be described more fully hereinafter with reference to the accompanying drawings, in which some example implementations are shown. In the drawings, like numerals refer to like elements throughout. The repeated descriptions may be omitted.

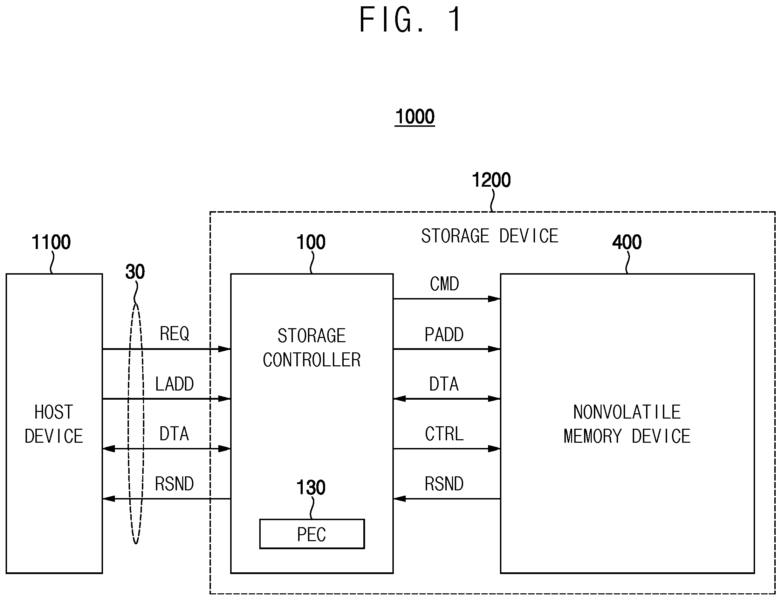

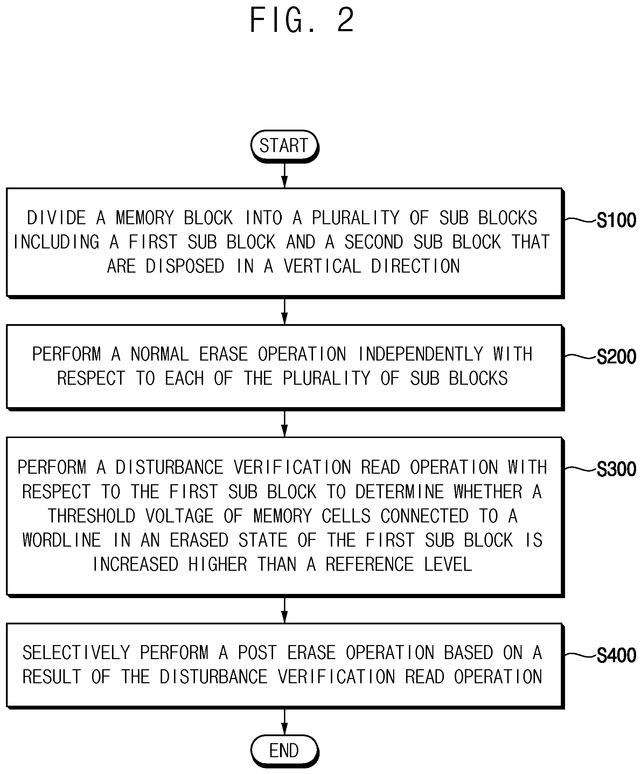

FIG. 1 is a block diagram illustrating a storage system according to some implementations, and FIG. 2 is a flowchart illustrating a method of controlling a nonvolatile memory device according to some implementations.

Referring to FIG. 1, a storage system 1000 includes a host device 1100, a storage device 1200 and a link 30 connecting the host device 1100 and the storage device 1200. The storage device 1200 may include a storage controller 100 and a nonvolatile memory device 400. The storage controller 100 may include a post erase controller PEC 130. For example, the storage device 1200 may be a solid state drive (SSD), an embedded multimedia card (eMMC), a universal flash storage (UFS), or the like. The link 30 may be a PCIe link.

The host device 1100 may be or include a data processing device such as a central processing unit (CPU), a microprocessor, an application processor (AP), or the like. The storage device 1200 may be embedded with the host device 1100 in an electronic device, or the storage device 1200 may be detachable to an electronic device including the host device 1100.

The host device 1100 may transfer a data operation request (which may be referred to herein as a request) REQ and associated logical addresses LADD to the storage controller 100 to communicate data DTA with the storage controller 100. The storage controller 100 may transfer a response RSND with respect to the request REQ to the host device 1100. The request REQ may include a read request, a program request, and/or an erase request, respectively associated with one or more read operations, program operations, and/or erase operations. The program request may be referred to as a write request.

The storage controller 100 may control the nonvolatile memory device 400 based on the request REQ. The storage controller 100 may provide physical addresses ADDR, commands CMD, and control signals CTRL to perform the read operations, the program operations, and/or the erase operations. The program operation may be referred to as a write operation. For example, the storage controller 100 may convert the logical addresses LADD from the host device 1100 to the physical addresses PADD by performing flash translation layer (FTL) operations.

The storage controller 100 may control the nonvolatile memory device 400 to read data DTA stored in the nonvolatile memory device 400 in response to the read request received from the host device 1100. The storage controller 100 may control the nonvolatile memory device 400 to write or program data DTA in the nonvolatile memory device 400 in response to the write or program request received from the host device 1100. The storage controller 100 may control the nonvolatile memory device 400 to erase data stored in the nonvolatile memory device 400 in response to the erase request received from the host device 1100. The nonvolatile memory device 400 may transfer a response RSND to the storage controller 100 in response to the command CMD.

The nonvolatile memory device 400 may be implemented with nonvolatile memory such as flash memory, MRAM (Magnetic RAM), FeRAM (Ferroelectric RAM), PRAM (Phase change RAM), ReRAM (Resistive RAM), or the like. The nonvolatile memory device 400 may be connected to the storage controller 100 through a plurality of channels. Hereinafter, some example implementations will be described based on NAND flash memory, but implementations are not limited to any particular kind of nonvolatile memory.

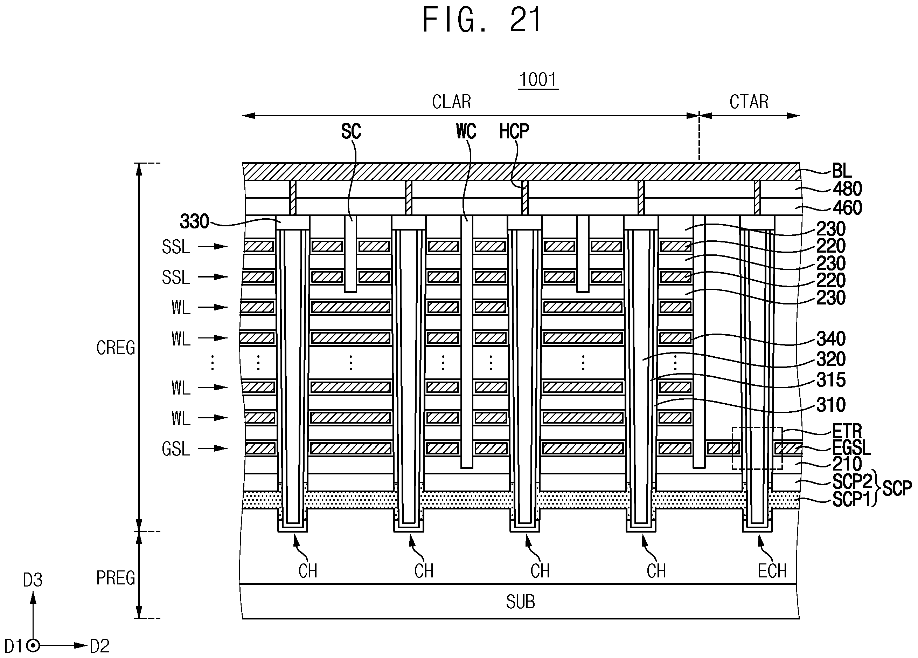

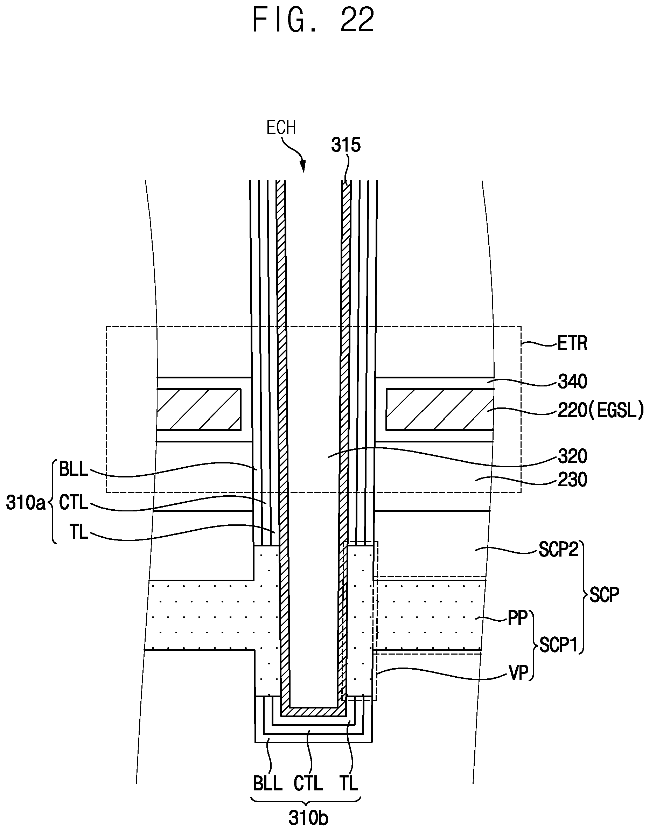

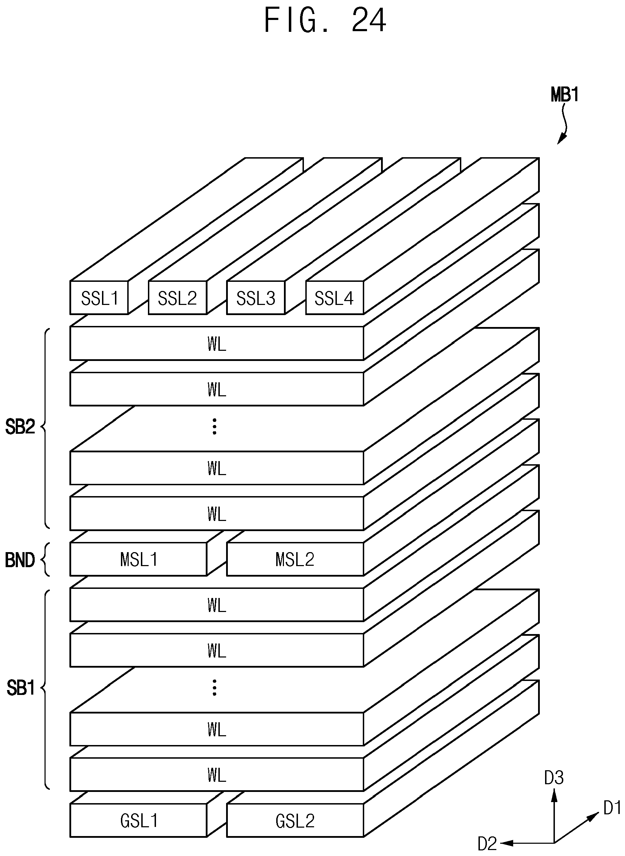

Referring to FIGS. 1 and 2, a memory block is divided into a plurality of sub blocks including a first sub block and a second sub block that are disposed in a vertical direction (S100). The memory block may include a plurality of cell strings and each cell string may include a plurality of memory cells that are disposed in the vertical direction. Example implementations of dividing the memory block will be described below with reference to FIG. 24. All memory blocks included in the nonvolatile memory device 400 may be divided into a plurality of sub blocks in the same way, or some memory blocks may be divided in different ways. As will be described below with reference to FIGS. 21 and 22, the sub blocks belonging to the same memory block may share the same channel.

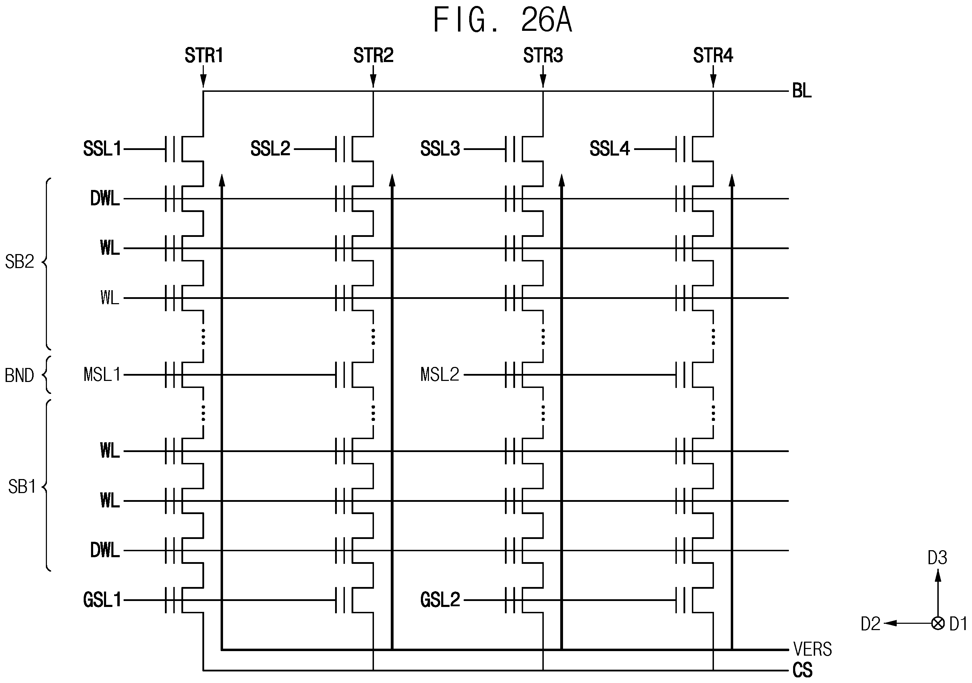

The nonvolatile memory device 400 may perform a normal erase operation independently with respect to each of the plurality of sub blocks (S200). The independent erase operation by units of sub blocks will be described below with reference to FIGS. 26A through 30B.

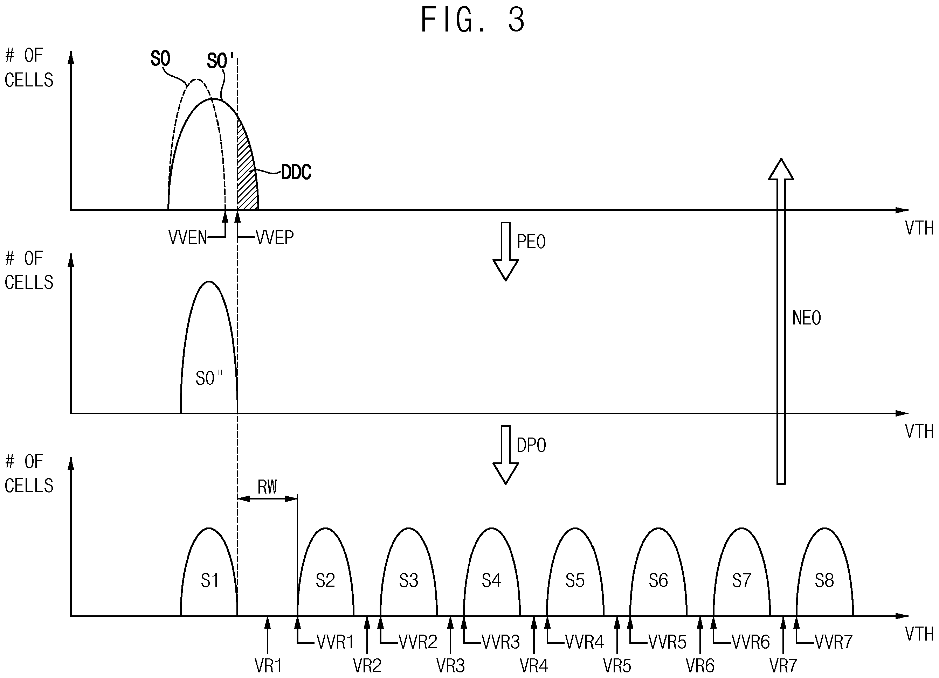

Under control of the post erase controller, the nonvolatile memory device 300 may perform a disturbance verification read operation with respect to the first sub block to determine whether a threshold voltage of memory cells connected to a wordline in an erased state of the first sub block is increased higher than a reference level by a program operation and a read operation with respect to the second sub block (S300). The first sub block may be referred to as a victim sub block and the second sub block may be referred to as an aggressor sub block. The disturbance verification read operation and the reference level will be described below with reference to FIG. 3.

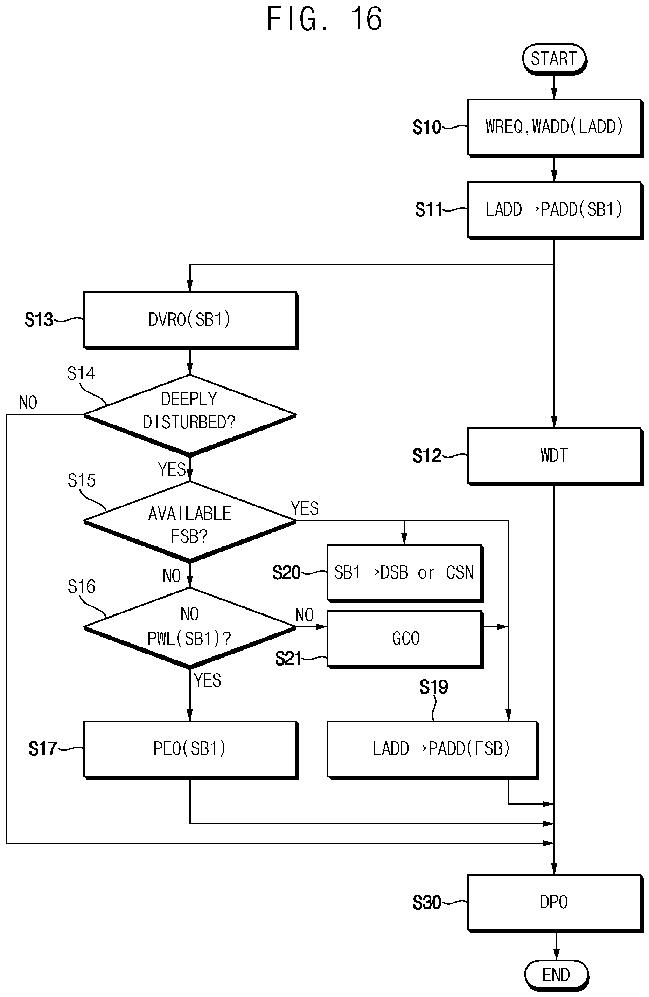

Under control of the post erase controller, the nonvolatile memory device 300 may selectively perform a post erase operation based on a result of the disturbance verification read operation to decrease the threshold voltage of memory cells in the erased state of the first sub block (S400). Example implementations of the selective post erase operation will be described below with reference to FIGS. 16, 17 and 18.

FIG. 3 is a diagram illustrating state change of memory cells in a method of controlling a nonvolatile memory device according to some implementations.

In FIG. 3, a horizontal axis represents a threshold voltage VTH of memory cells, and a vertical axis represents the number of the memory cells corresponding to the threshold voltage VTH. Although FIG. 3 shows a triple level cell (TLC) scheme in which each memory cell stores a 3-bit value, example implementations are not limited thereto, and the number of bits stored in each selected memory cell may be determined variously.

Referring to FIG. 3, the memory cells are erased to have threshold voltages lower than a normal erase verification voltage VVEN by the normal erase operation. Thereafter, the threshold voltages of the memory cells may increase due to disturbances in program operations and read operations of adjacent wordlines. As a result, as shown in FIG. 3, the threshold voltage range may be widened from the initial erased state S0 by the normal erase operation NEO to the erased state S0' due to the disturbances. In this case, the threshold voltages of some memory cells may be increased higher than a reference level, that is, the post erase verification voltage VVEP, and these memory cells may be referred to as deeply-disturbed memory cells DDC.

The threshold voltage of the deeply-disturbed memory cells DDC may be reduced to be lower than the post erase verification voltage VVEP by performing the post erase operation PEO. As a result, as shown in FIG. 3, the erased state SO" after the post erase operation PEO has a narrower threshold voltage range than the erased state SO' before the post erase operation PEO.

After that, a data program operation DPO may be performed such that each memory cell corresponds to one state depending on the write data among the first through eighth states S1~S8. Here, the first state S1 corresponds to an unprogrammed erased state. During the data program operation DPO, the program execution results for the first through eighth states S1~S8 may be determined by sequentially applying the first through seventh data verification read voltages VVR1~VVR7 to the selected wordline. Also, during the read operation, each bit of the first through eighth states S1~S8 may be determined by sequentially applying some of the normal read voltages VR1~VR7 to the selected wordline.

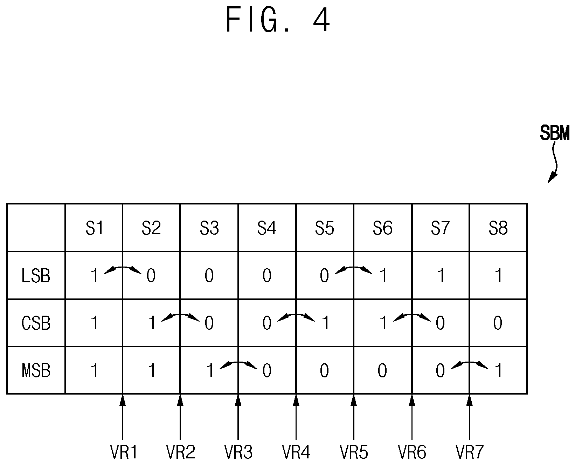

FIG. 4 is a diagram illustrating an example of state-bit mapping information indicating mapping relationship between states in FIG. 3 and bit values.

Referring to FIG. 4, state-bit mapping information SBM indicates the mapping relationships between the states and the bits stored in the plurality of multi-level cells. FIG. 4 illustrates an example of bit values corresponding to the first through eighth states S1~S8 in FIG. 3. The first through eighth states S1~S8 may be represented by different values corresponding to least significant bit (LSB), a centered bit (CSB) and a most significant bit (MSB), that is, different values of first, second and third bits LSB, CSB and MSB. For example, as illustrated in FIG. 4, the first state S1 corresponds to '111', the second state S2 corresponds to '110', the third state S3 corresponds to '100', the fourth state S4 corresponds to '000', the fifth S5 state corresponds to '010', the sixth S6 state corresponds to '011', the seventh state S7 corresponds to '001', and the eighth state S8 corresponds to '101'. According to some implementations, each reliability of the read bits may be adjusted based on the state-bit mapping information SBM.

In this case, the first bit LSB may be determined using the first read voltage VR1 and the fifth read voltage VR5, the second bit CSB may be determined using the second read voltage VR2, the fourth read voltage VR4 and the sixth read voltage VR6, and the third bit MSB may be determined using the third read voltage VR3 and the seventh read voltage VR7.

In the deeply-disturbed state, holes are reduced in the charge storage layer of the memory cell in the erased state, and the read margin or the read window RW may be narrowed due to the over-disturbance. As the read window RW becomes narrower, errors in discriminating between the erased first state S1 and the programmed second state S2 increase and performance of the nonvolatile memory device deteriorates.

In a nonvolatile memory device such as a conventional vertical NAND (VNAND) flash memory device, since erasing is possible only by units of memory blocks, disturbance by arbitrary read, program, and erase operations after erasure may be controlled. In the erase method by units of memory blocks, only program disturbance as many as the number of wordlines by the program operation has been allowed after erase operation is performed, and the operations of the nonvolatile memory device may be managed by predicting the allowable disturbance in advance.

However, when the erase operation is permitted by units of sub blocks, disturbances that are difficult to predict are accumulated in the victim sub blocks due to the operation of the aggressor sub blocks while the victim sub blocks are in the erased state. If data is written to the victim sub block without checking any disturbance by the aggressor sub block, the reliability of the nonvolatile memory device may deteriorate.

The nonvolatile memory device and the method of controlling the nonvolatile memory device according to some implementations may reduce unnecessary erasure of memory cells and increase the lifespan of the nonvolatile memory device by grouping the memory block into the sub blocks to manage the erase operation. In addition, the reliability of the nonvolatile memory device may be secured and the performance of the nonvolatile memory device may be enhanced by reducing the disturbance caused in the victim sub block by the aggressor sub block through the post erase operation.

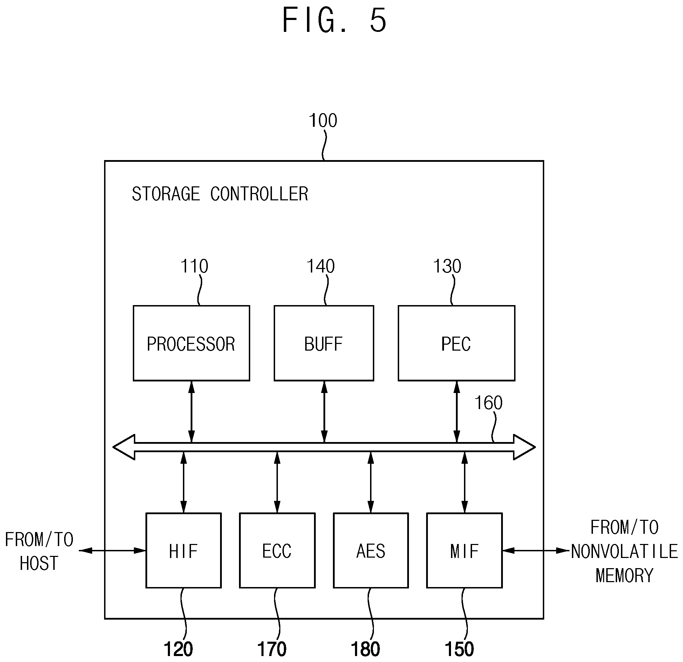

FIG. 5 is a block diagram illustrating a storage controller according to some implementations.

Referring to FIG. 5, a storage controller 100 includes a processor 110, a buffer memory (BUFF) 140, a post erase controller (PEC) 130, a host interface (HIF) 120, an error correction code (ECC) engine 170, a memory interface (MIF) 150, an advanced encryption standard (AES) engine 180, and an internal bus system 160 that connects the components in the storage controller 100.

The processor 110 may control an operation of the storage controller 100 in response to commands received via the host interface 120 from a host device (e.g., the host device 1100 in FIG. 1). For example, the processor 110 may control an operation of a storage device (e.g., the storage device 1200 in FIG. 1), and may control respective components by employing firmware for operating the storage device.

The buffer memory 140 may store instructions and data executed and processed by the processor 110. For example, the buffer memory 140 may be implemented with a volatile memory, such as a DRAM, a SRAM, a cache memory, or the like.

The ECC engine 170 for error correction may perform coded modulation using a Bose-Chaudhuri-Hocquenghem (BCH) code, a low density parity check (LDPC) code, a turbo code, a Reed-Solomon code, a convolution code, a recursive systematic code (RSC), a trellis-coded modulation (TCM), a block coded modulation (BCM), or the like. In some example implementations, the ECC engine 170 may perform ECC encoding and ECC decoding using above-described codes or other error correction codes.

The host interface 120 may provide physical connections between the host device 1100 and the storage device 1200. The host interface 120 may provide an interface that corresponds to a bus format of the host device 1100 for communication between the host device 1100 and the storage device 1200. In some example implementations, the bus format of the host device 1100 may be a small computer system interface (SCSI) or a serial attached SCSI (SAS) interface. In other example implementations, the bus format of the host device may be a USB, a peripheral component interconnect (PCI) express (PCIe), an advanced technology attachment (ATA), a parallel ATA (PATA), a SATA, a nonvolatile memory (NVM) express (NVMe), or other format.

The memory interface 150 may exchange data with a nonvolatile memory device (e.g., the nonvolatile memory device 400 in FIG. 1). The memory interface 150 may transfer data to the nonvolatile memory device 400, and/or may receive data read from the nonvolatile memory device 400. In some example implementations, the memory interface 150 may be connected to the nonvolatile memory device 400 via one channel. In other example implementations, the memory interface 150 may be connected to the nonvolatile memory device 400 via two or more channels. The memory interface 150 may be configured to comply with a standard protocol, such as Toggle or open NAND flash interface (ONFI).

The AES engine 180 may perform at least one of an encryption operation and a decryption operation on data input to the storage controller 100 using a symmetric-key algorithm. The AES engine 180 may include an encryption module and a decryption module. For example, the encryption module and the decryption module may be implemented as separate modules. In another example, one module capable of performing both encryption and decryption operations may be implemented in the AES engine 180.

The post erase controller 130 may control the nonvolatile memory device to perform the disturbance verification read operation and the post erase operation as described above.

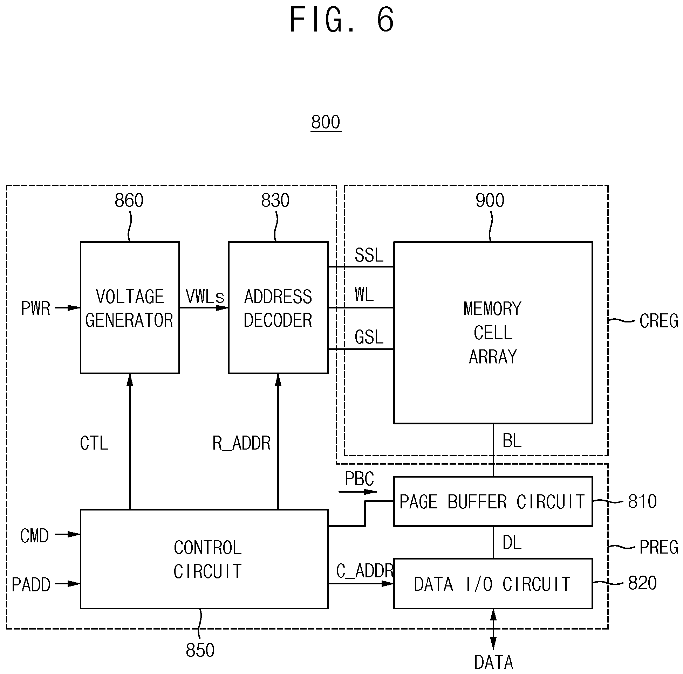

FIG. 6 is a block diagram illustrating a nonvolatile memory device according to some implementations.

Referring to FIG. 6, a nonvolatile memory device 800 includes a memory cell array 900, a page buffer circuit 810, a data input/output (I//O) circuit 820, an address decoder 830, a control circuit 850, and a voltage generator 860. In some example implementations, the nonvolatile memory device 800 may have a cell over periphery (COP) structure in which a memory cell array is arranged over peripheral circuits. In this case, the memory cell array 900 may be formed in a cell region CREG, and the page buffer circuit 810, the data I/O circuit 820, the address decoder 830, the control circuit 850, and the voltage generator 860 may be formed in a peripheral region PREG.

The memory cell array 900 may be coupled to the address decoder 830 through string selection lines SSL, wordlines WL, and ground selection lines GSL. The memory cell array 900 may be coupled to the page buffer circuit 810 through bitlines BL. The memory cell array 900 may include memory cells coupled to the wordlines WL and the bitlines BL. In some example implementations, the memory cell array 900 may be a three-dimensional memory cell array, which may be formed on a substrate in a three-dimensional structure (or a vertical structure). In this case, the memory cell array 900 may include cell strings (e.g., NAND strings) that are vertically oriented such that at least one memory cell is located over another memory cell.

The control circuit 850 may receive a command signal CMD and an address signal PADD from a memory controller, and may control erase, program, and read operations of the nonvolatile memory device 800 in response to (or based on) at least one of the command signal CMD and the address signal PADD. The erase operation may include performing a sequence of erase loops, and the program operation may include performing a sequence of program loops. Each program loop may include a program operation and a program verification operation. Each erase loop may include an erase operation and an erase verification operation. The read operation may include a normal read operation and data recover read operation.

In some example implementations, the control circuit 850 generates a control signals CTL used to control the operation of the voltage generator 860, and may generate a page buffer control signal PBC for controlling the page buffer circuit 810, based on the command signal CMD, and may generate a row address R_ADDR and a column address C_ADDR based on the address signal PADD. The control circuit 850 may provide the row address R_ADDR to the address decoder 530, and may provide the column address C_ADDR to the data I/O circuit 520.

The address decoder 830 may be coupled to the memory cell array 900 through the string selection lines SSL, the wordlines WL, and the ground selection lines GSL.

Hereinafter, an erase operation may be understood to include both of the normal erase operation NEO and the post erase operation PEO as described above.

During the program operation or the read operation, the address decoder 530 may determine (or select) one of the wordlines WL as a selected wordline, and may determine or designate the remaining wordlines WL other than the selected wordline as unselected wordlines based on the row address R_ADDR.

In addition, during the program operation or the read operation, the address decoder 830 may determine one of the string selection lines SSL as a selected string selection line and determine or designate the remaining the string selection lines SSL other than the selected string selection line as unselected string selection lines based on the row address R_ADDR. The aforementioned selected memory cells correspond to the memory cells connected to the selected wordline and the selected string selection line.

The voltage generator 860 may generate wordline voltages VWL, which are used for the operation of the memory cell array 900 of the nonvolatile memory device 800, based on the control signals CTL. The voltage generator 860 may receive the power PWR from the memory controller. The wordline voltages VWL may be applied to the wordlines WL through the address decoder 830.

In some example implementations, during the erase operation, the voltage generator 860 applies an erase voltage to a well and/or a common source line of a memory block, and may apply an erase permission voltage (e.g., a ground voltage) to all of the wordlines of the memory block or a portion of the wordlines based on an erase address. During the erase verification operation, the voltage generator 860 may apply an erase verification voltage simultaneously to all of the wordlines of the memory block or sequentially (e.g., one by one) to the wordlines.

In some example implementations, during the program operation, the voltage generator 860 applies a program voltage to the selected wordline, and may apply a program pass voltage to the unselected wordlines. During the program verification operation, the voltage generator 860 may apply a program verification voltage to the first wordline, and may apply a verification pass voltage to the unselected wordlines.

During the normal read operation, the voltage generator 860 may apply a read voltage to the selected wordline, and may apply a read pass voltage to the unselected wordlines. During the data recover read operation, the voltage generator 860 may apply the read voltage to a wordline adjacent to the selected wordline, and may apply a recover read voltage to the selected wordline.

The page buffer circuit 810 may be coupled to the memory cell array 900 through the bitlines BL. The page buffer circuit 810 may include multiple buffers. In some example implementations, each buffer is connected to only a single bitline. In some example implementations, each buffer is connected to two or more bitlines. The page buffer circuit 810 may temporarily store data to be programmed in a selected page or data read out from the selected page of the memory cell array 900.

The data I/O circuit 820 may be coupled to the page buffer circuit 810 through data lines DL. During the program operation, the data I/O circuit 820 may receive program data DATA received from the memory controller and provide the program data DATA to the page buffer circuit 810 based on the column address C_ADDR received from the control circuit 850. During the read operation, the data I/O circuit 820 may provide read data DATA, read from the memory cell array 900 and stored in the page buffer circuit 810, to the memory controller based on the column address C_ADDR received from the control circuit 850.

The page buffer circuit 810 and the data I/O circuit 820 may read data from a first area of the memory cell array 900, and may write this read data to a second area of the memory cell array 900 (e.g., without transmitting the data to a source external to the nonvolatile memory device 800, such as to the memory controller). Thus, the page buffer circuit 810 and the data I/O circuit 820 may perform a copy-back operation.

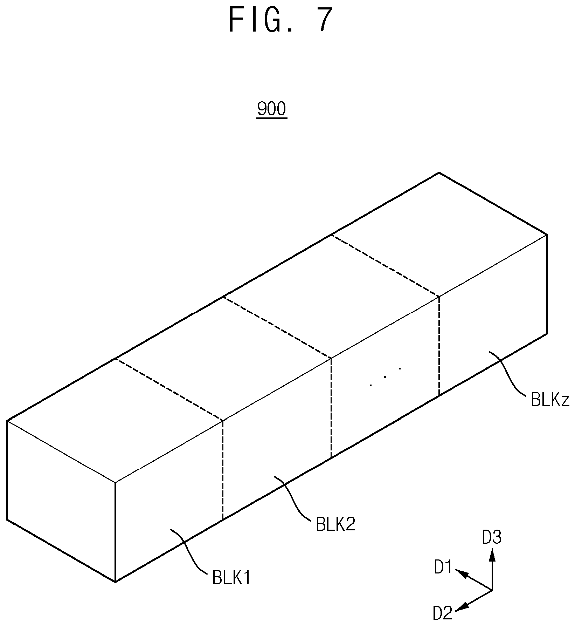

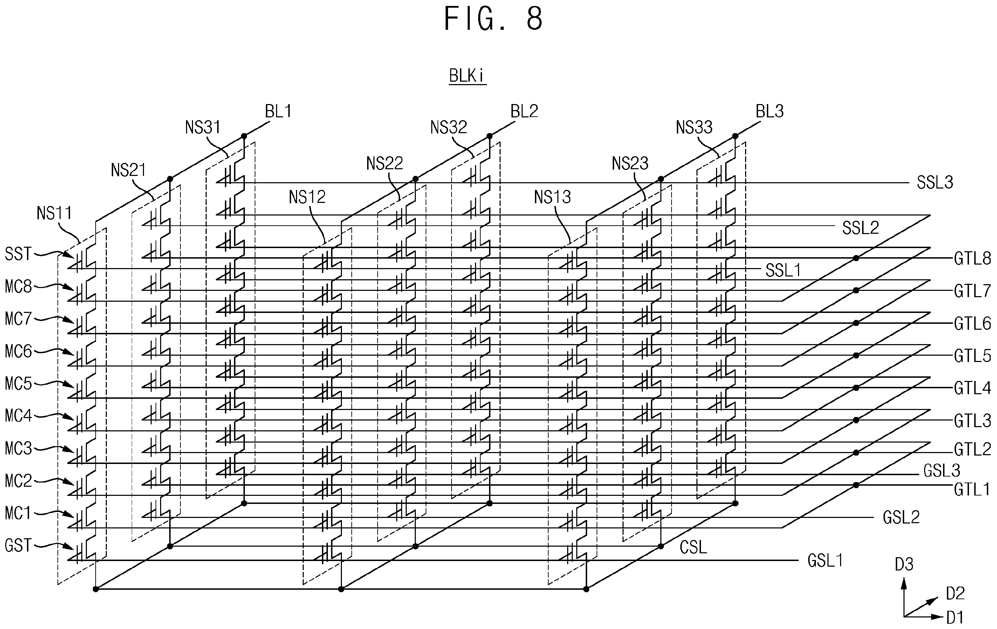

FIG. 7 is a block diagram illustrating a memory cell array included in the nonvolatile memory device of FIG. 6, and FIG. 8 is a circuit diagram illustrating an equivalent circuit of a memory block included in the memory cell array of FIG. 7.

Referring to FIG. 7, the memory cell array 900 includes memory blocks BLK1 to BLKz. In some example implementations, the memory blocks BLK1 to BLKz are selected by the address decoder 830 of FIG. 6. For example, the address decoder 830 may select a particular memory block BLK corresponding to a block address among the memory blocks BLK1 to BLKz.

A memory block BLKi (i being an integer from 1 to z) of FIG. 8 may be formed on a substrate in a three-dimensional structure (or a vertical structure). For example, NAND strings or cell strings included in the memory block BLKi may be formed in a vertical direction D3 perpendicular to an upper surface of a substrate.

Referring to FIG. 8, the memory block BLKi may include NAND strings NS11 to NS33 coupled between bitlines BL1, BL2, and BL3 and a common source line CSL. Each of the NAND strings NS11 to NS33 may include a string selection transistor SST, a memory cells MC1 to MC8, and a ground selection transistor GST. In FIG. 8, each of the NAND strings NS11 to NS33 is illustrated to include eight memory cells MC1 to MC8. However, implementations are not limited thereto, and each of the NAND strings NS11 to NS33 may include various numbers of memory cells.

Each string selection transistor SST may be connected to a corresponding string selection line (one of SSL1 to SSL3). The memory cells MC1 to MC8 may be connected to corresponding gate lines GTL1 to GTL8, respectively. The gate lines GTL1 to GTL8 may be wordlines, and some of the gate lines GTL1 to GTL8 may be dummy wordlines. Each ground selection transistor GST may be connected to a corresponding ground selection line (one of GSL1 to GSL3). Each string selection transistor SST may be connected to a corresponding bitline (e.g., one of BL1, BL2, and BL3), and each ground selection transistor GST may be connected to the common source line CSL.

Wordlines (e.g., WL1) having the same or similar height may be commonly connected, and the ground selection lines GSL1 to GSL3 and the string selection lines SSL1 to SSL3 may be separated. In FIG. 8, the memory block BLKi is illustrated as being coupled to eight gate lines GTL1 to GTL8 and three bitlines BL1 to BL3. However, implementations are not limited thereto, and each memory block in the memory cell array 500 may be coupled to various numbers of wordlines and various numbers of bitlines.

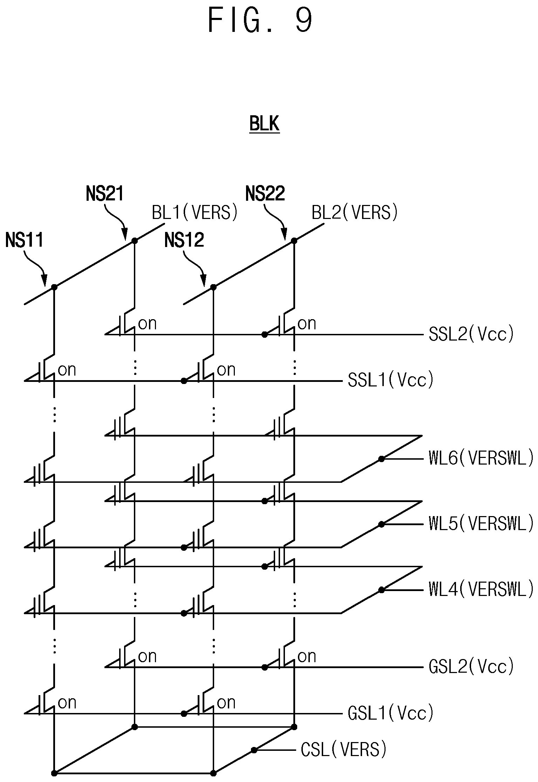

FIG. 9 is a circuit diagram illustrating an erase bias condition of a nonvolatile memory device according to some implementations.

For convenience of description, NAND strings NS11 and NS21 connected to a first bitline BL1 and NAND strings NS12 and NS22 connected to a second bitline BL2 are illustrated in FIG. 9.

During an erase operation, an erase voltage VERS may be applied to the first bitline BL1 and the second bitline BL2. In this case, the power supply voltage Vcc, for example, is applied to the first string selection line SSL1 and the second string selection line SSL2. Also, during the erase operation, the erase voltage VERS may be applied to the common source line CSL. In this case, the power supply voltage Vcc may be applied to the first ground selection line GSL1 and the second ground selection line GSL2. The erase enable voltage VERSWL may be applied to the wordlines WL4, WL5 and WL6.

Under this erase bias condition, voltages of the drain and source of the memory cells of the memory block may be, for example, 20V, and a voltage of, for example, 0V may be applied to the gate. The voltage generator 860 of FIG. 6 may generate the erase voltage VERS applied to the bitlines BL1 and BL2 and/or the common source line CSL during the erase operation.

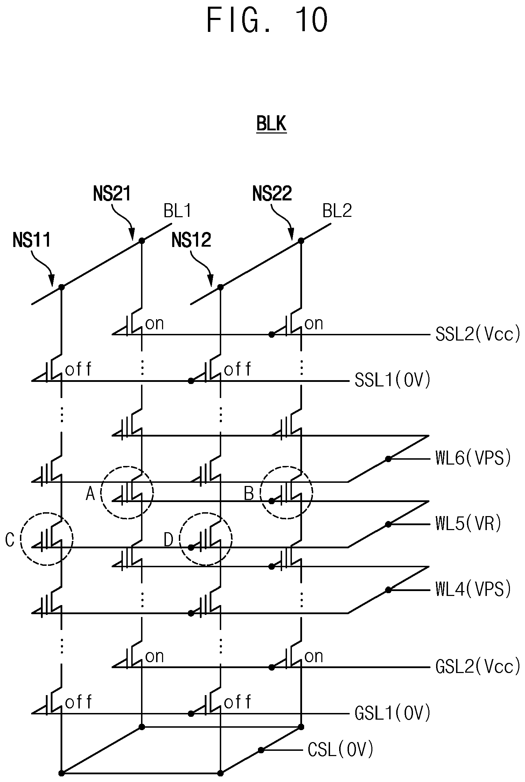

FIG. 10 is a circuit diagram illustrating a read bias condition of a nonvolatile memory device according to some implementations.

For convenience of description, NAND strings NS11 and NS21 connected to a first bitline BL1 and NAND strings NS12 and NS22 connected to a second bitline BL2 are illustrated in FIG. 10.

The first bitline BL1 and the second bitline BL2 may be precharged with a precharge voltage (e.g., 0.5 V). During a read operation, if NAND strings NS21 and NS22 are selected, a voltage of 0 V may be applied to the first string selection line SSL1 and a power supply voltage Vcc may be applied to the second string selection line SSL2. Furthermore, the voltage of 0 V may be applied to a first ground selection line GSL1 and the power supply voltage Vcc may be applied to a second ground selection line GSL2. A read voltage VR may be applied to a selected wordline (e.g., WL5) and a read pass voltage VPS may be applied to unselected wordlines (e.g., WL4 and WL6).

In this exemplary read bias condition, the drain voltage of selected memory cells A and B may be, for example, 0.5 V and the source voltage of selected memory cells A and B may be, for example, 0 V. In addition, the read voltage VR is applied to gates of the selected memory cells A and B. Furthermore, a read operation for verifying data stored at a memory cell may be performed while changing a voltage level of the read voltage VR. Channels of unselected NAND strings NS11 and NS12 including memory cells C and D are floated. The voltage generator 860 of FIG. 6 may generate the read voltage VR and the read pass voltage VPS applied to the plurality of wordlines during the read operation.

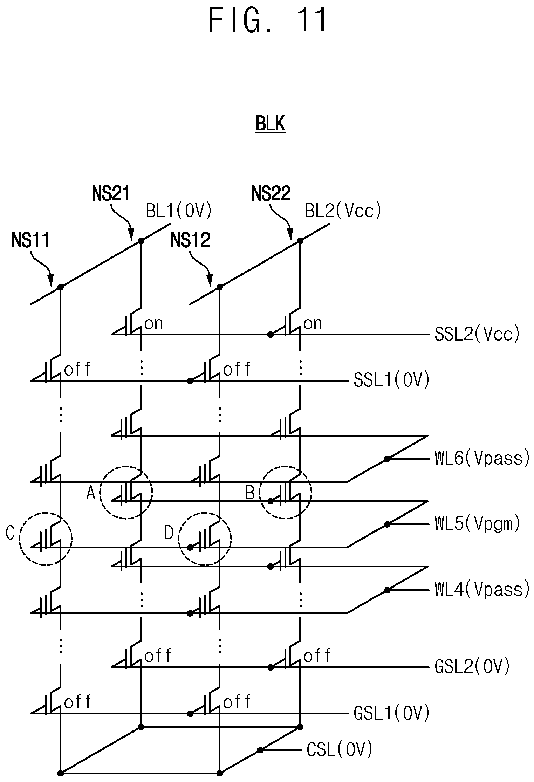

FIG. 11 is a circuit diagram illustrating a program bias condition of a nonvolatile memory device according to some implementations.

For convenience of description, NAND strings NS11 and NS21 connected to a first bitline BL1 and NAND strings NS12 and NS22 connected to a second bitline BL2 are illustrated in FIG. 11.

The first bitline BL1 may be a program bitline to which a program permission voltage (e.g., 0 V) is applied, and the second bitline BL2 may be a program inhibition bitline to which a program inhibition voltage such as a power supply voltage Vcc is applied. If the NAND string NS21 among the NAND strings NS11 and NS21 is selected, during a program operation, a voltage of 0 V may be applied to a first string selection line SSL1, and the power supply voltage Vcc may be applied to a second string selection line SSL2.

The voltage of 0 V may be applied to ground selection lines GSL1 and GSL2. Furthermore, a voltage (e.g., Vcc) higher than 0 V may be applied to a common source line CSL. A program voltage Vpgm (e.g., 18 V) may be applied to a selected wordline (e.g., WL5) and a pass voltage Vpass (e.g., 8 V) may be applied to unselected wordlines (e.g., WL4 and WL6).

Under the program bias condition, the program voltage Vpgm of 18V may be applied to a gate of a memory cell A having a channel voltage of 0 V. Since a strong electric field is formed between the gate and a channel of the memory cell A, the memory cell A may be programmed. However, since respective channels of memory cells C and D are in a floating state, channel voltages thereof may be boosted up to, for example, about 8 V, and thus, the memory cells C and D may not be programmed. The memory cell B may not be programmed because a weak electric field is formed between the gate of the memory cell B and the channel. The voltage generator 860 of FIG. 6 generates the program voltage Vpgm and the program pass voltage Vpass applied to the plurality of wordlines during the program operation.

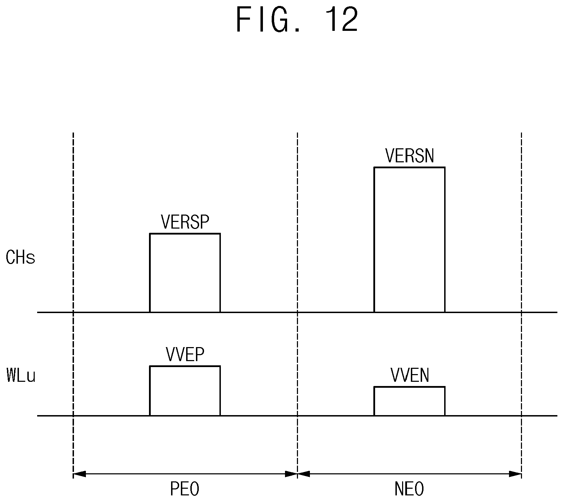

FIG. 12 is a diagram illustrating voltages in a post erase operation and a normal erase operation according to some implementations.

A threshold voltage distribution to be formed by the post erase operation PEO may be set slightly higher than a threshold voltage distribution to be formed by the normal erase operation NEO. In other words, as shown in FIG. 12, the post erase verification voltage VVEP for the post erase operation PEO may be set higher than the normal erase verification voltage VVEN for the normal erase operation NEO. When the disturbance verification read operation DVRO is performed, the post erase verification voltage VVEP higher than the normal erase verification voltage VVEN for the normal erase operation NEO may be applied to the wordline WLu in the erased state of the first sub block corresponding to the victim sub block. The wordline WLu, which is the object of the disturbance verification read operation DVRO, may be preset in an appropriate manner according to the characteristics of the nonvolatile memory device. For example, at least one wordline that is most vulnerable to disturbance may be set as the wordline WLu for the disturbance verification read operation DVRO.

To prevent over-erasing by the post erase operation PEO, as shown in FIG. 12, the post erase voltage VERSP for the post erase operation PEO may be set slightly lower than the normal erase voltage VERSN for the normal erase operation NEO. In other words, when performing the post erase operation PEO, the normal erase voltage for the normal erase operation (NEO), the post erase voltage VERSP lower than the normal erase voltage VERSN may be applied to the channels CHs of the first sub block corresponding to the victim sub block. Meanwhile, to verify the post erase operation PEO, a post erase verification voltage VVEP higher than the normal erase verification voltage VVEN for the normal erase operation NEO may be applied to the wordline WLu in the erased state of the first sub block. The post erase verification voltage VVEP applied to the wordline WLu in the disturbance verification read operation DVRO may be the same as or different from the post erase verification voltage VVEP applied to the wordline WLu in the erase verification operation of the post erase operation PEO.

In this way, operating conditions such as the erase voltage and the erase verification read voltage may be set differently for the post erase operation PEO and the normal erase operation NEO. In addition to the voltage, a voltage application time, an allowable number of error bits for an erase pass condition, and the number of erase loops may be set differently for the erase operation PEO and the normal erase operation NEO.

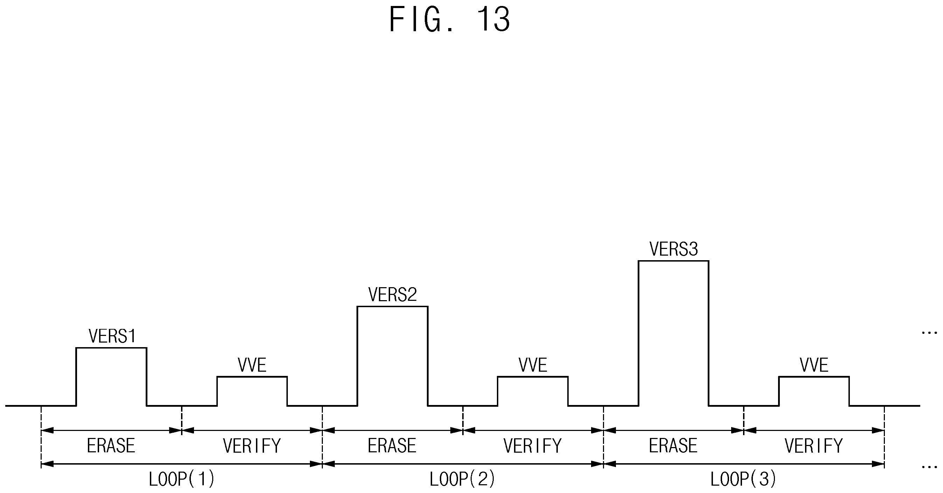

FIG. 13 is a diagram illustrating an erase operation according to an incremental step pulse erasing (ISPE).

Referring to FIG. 13, a plurality of erase loops LOOP(1), LOOP(2), LOOP(3), ... are sequentially performed according to ISPE until erase is completed. As the erase loop is repeated, the erase voltages VERS1, VERS2, VERS3, ... may increase step by step.

Each erase loop LOOP(i) (i is a natural number) may include an erase period ERASE and an erase verification period VERIFY. In order to erase the memory cells during the erase period ERASE, the erase voltages VERS1, VERS2, VERS3, ... may be applied to channels and an erase permission voltage may be applied to wordlines. Thereafter, the erase verification voltage VVE may be applied to the wordline during the erase verify period VERIFY in order to verify whether the erase is successful.

The erase operation and the erase verification operation may be repeatedly performed while increasing the erase voltages VERS1 , VERS2 , VERS3 , ... until a pass condition is satisfied. Here, the pass condition represents the maximum allowable number of memory cells whose threshold voltage is higher than the erase verification voltage VVE among the selected memory cells to be erased. The erase loop may be repeated until the number of unerased memory cells becomes smaller than the maximum allowable number. The maximum allowable number may be determined according to the ECC level of the nonvolatile memory device.

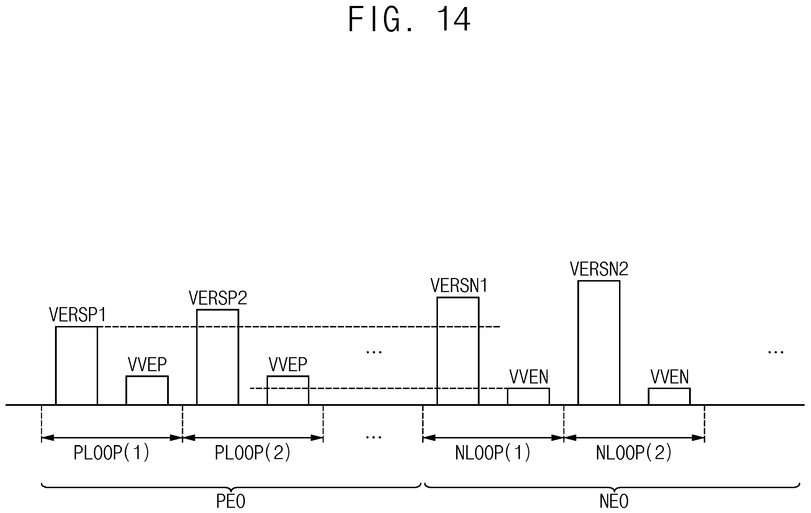

FIG. 14 is a diagram illustrating voltages in a post erase operation and a normal erase operation according to an ISPE according to some implementations.

Referring to FIG. 14, the ISPE described with reference to FIG. 13 is applied to the post erase operation PEO and the normal erase operation NEO, respectively. The post erase operation PEO may include post erase loops PLOOP(1) and PLOOP(2) respectively corresponding to the post erase voltages VERSP1 and VERSP2, and the normal erase operation NEO may include normal erase loops NLOOP(1) and NLOOP(2) respectively corresponding to the normal erase voltages VERSN1 and VERSN2. As described above, the post erase verification voltage VVEP for the post erase operation PEO may be higher than the normal erase verification voltage VVEN for the normal erase operation NEO. Also, the post erase voltages VERSP1 and VERSP2 for the post erase operation PEO may be lower than the normal erase voltages VERSN1 and VERSN2 for the normal erase operation NEO.

As shown in FIG. 14, when the normal erase operation NEO and the post erase operation PEO are performed according to the ISPE scheme, the post erase voltage VERSP1of the first erase loop PLOOP(1) of the post erase operation PEO may be lower than the normal erase voltage VERSN1 of the first erase loop NLOOP(1) of the normal erase operation NEO. By setting the post erase voltage VERSP to be lower than the normal erase voltage VERSN, over-erase by the post-erase operation PEO may be prevented or reduced.

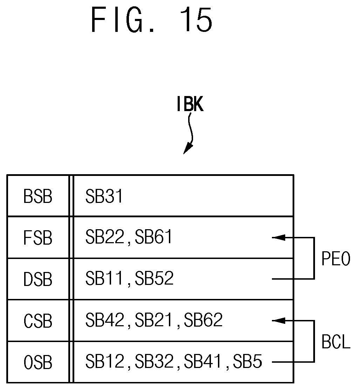

FIG. 15 is a diagram illustrating an example of block information in a method of controlling a nonvolatile memory device according to some implementations.

Referring to FIG. 15, block information IBK includes information about a bad sub block BSB, a free sub block FSB, a deeply-disturbed sub block DSB, a closed sub block CSB, and an open sub block OSB. The block information IBK may be one of metadata generated and managed to control the nonvolatile memory device.

A bad sub block BSB may indicate a sub block that is unusable due to a defect. The free sub block FSB may indicate a sub block on which a program operation has not yet been performed after a normal erase operation NEO has been performed. The deeply-disturbed sub block DSB corresponds to the free sub block FSB that is determined by the above-described disturbance verification read operation DVRO that the threshold voltage of the memory cells connected to the wordline in the erased state is increased higher than the reference level. The closed sub block CSB may indicate a sub block from which further program operations are inhibited. The open sub block OSB may indicate a sub block capable of program operation.

In FIG. 15, SBij may indicate a j-th sub block belonging to an i-th memory block. For example, the second sub block SB22 of the second memory block corresponds to the free sub block FSB, and the first sub block SB11 of the first memory block corresponds to the deeply-disturbed sub block DSB.

In some implementations, the deeply-disturbed sub block DSB is converted into the free sub block FSB by performing the post erase operation PEO with respect to the deeply-disturbed sub block DSB. According to some implementations, the post erase operation PEO is performed as a background operation or may be performed as a foreground operation. The background operation represents an operation performed in an idle state of the nonvolatile memory device, and the foreground operation represents an operation performed in an active mode of the nonvolatile memory device. The background operation may be suspended or delayed by a request for another operation from the host, and the foreground operation may be performed prior to a request for another operation from the host.

In some implementations, the open sub block OSB is converted into a closed sub block DSB by performing a block close BCL with respect to the open sub block OSB. The block close BCL indicates prohibiting further programming for the corresponding sub block.

FIG. 16 is a flowchart illustrating a method of controlling a nonvolatile memory device according to some implementations.

Referring to FIGS. 1 and 16, the storage device 1200 receives a write request WREQ and a logical address LADD corresponding to a write address WADD from the host device 1100 (S10). The storage controller 100 may perform an FTL operation to convert the logical address LADD transmitted from the host device 1100 into a physical address PADD corresponding to the first sub block SB1 (S11).

The write data WDT is transmitted from the host device 1100 to the storage device 1200 (S12), and the storage controller 100 may control the nonvolatile memory device 400 to perform a data program operation DPO (S30) of writing the write data WDT into the selected memory cells corresponding to the physical address PADD.

Meanwhile, when the first sub block SB1 corresponding to the physical address PADD is determined, the post erase controller 130 performs the disturbance verification read operation DVRO with respect to the first sub block SB1 (S13) to determine whether the threshold voltage of the memory cells connected to the wordline in the erased state of the first sub block SB1 is increased higher than the reference level, that is, whether the first sub block SB1 is deeply disturbed. The disturbance verification read operation DVRO may be performed before performing the data program operation DPO with respect to the first sub block SB1.

When the first sub block SB1 is not deeply-disturbed (S14: NO), the storage controller 100 transmits the physical address PADD corresponding to the first sub block SB1 to the nonvolatile memory device 400 and then the nonvolatile memory device 400 may perform the data program operation DPO to store the write data WDT in the physical address PADD of the first sub block SB1. In other words, when the result of the disturbance verification read operation DVRO indicates that the threshold voltage of the memory cells connected to the wordline in the erased state of the first sub block SB1 is not increased higher than the reference level, the post erase operation PEO with respect to the first sub block SB1 may be omitted and the program operation with respect to the first sub block SB1 may be performed.

When the first sub block SB1 is deeply-disturbed (S14: YES), that is, when the result of the disturbance verification read operation DVRO indicates that the threshold voltage of the memory cells connected to the wordline in the erased state of the first sub block SB1 is increased higher than the reference level, the post erase controller 130 may determine whether there exists an available (or usable) free sub block FSB in the erased state by referring to the block information IBK of FIG. 15 (S15). For example, the post erase controller 130 may determine that there are usable free sub blocks FSBs when the number of free sub blocks registered in the block information IBK is equal to or greater than a predetermined reference number.

When there exists an available free sub block FSB (S15: YES), the storage controller 100 performs an FTL operation to convert the logical address LADD to the physical address PADD corresponding to the available free sub block FSB (S19). The storage controller 100 transmits the physical address PADD corresponding to the free sub block FSB to the nonvolatile memory device 400, and the nonvolatile memory device 400 may perform the data program operation DPO (S30) to store the write data WDT in the memory cells corresponding to the physical address PADD of the free sub block FSB. In other words, when there exists an available free sub block FSB (S15: YES), the program operation with respect to the first sub block SB1 may be replaced with the program operation with respect to the available free sub block FSB. Meanwhile, the post erase controller 130 may set the first sub block SB1 as the deeply-disturbed sub block DSB or the closed sub block CSB S20 to inhibit programming of the first sub block SB1. When the first sub block SB1 corresponds to the deeply-disturbed sub block DSB in which all wordlines are in the erased state, the storage controller 100 may perform the post erase operation PEO with respect to the first sub block SB1 as the background operation. After the post erase operation PEO with respect to the first sub block SB1 is completed, the first sub block SB1 may be set as a free sub block FSB.

When there is no available free sub block (S15: NO), the post erase controller 130 determines whether all wordlines of the first sub block SB1 are in the erased state, that is, whether there is no wordline PWL corresponding to the program state (S16).

When all wordlines of the first sub -block SB1 are in the erased state (S16: YES), the storage controller 400 may control the nonvolatile memory device 400 to perform the post erase operation PEO with respect to the first sub block SB1. Then, the storage controller 100 transfers the physical address PADD corresponding to the first sub block SB1 to the nonvolatile memory device 400, and the nonvolatile memory device 400 may perform the data program operation DPO (S30) to store the write data WDT in the physical address PADD corresponding to the first sub block SB1. In other words, when there is no available free sub block FSB (S15: NO) and all wordlines of the first sub block SB1 are in the erased state (S16: YES), the nonvolatile memory device 400 may perform the program operation with respect to the first sub block SB1 after performing the post erase operation PEO with respect to the first sub block SB1.

Meanwhile, when at least one wordline of the first sub block SB1 is in a programmed state (S16: NO), the storage controller 100 may control the nonvolatile memory device 400 to perform a garbage collection operation GCO (S21) and secure (or generate) usable free sub blocks FSB. Then, the storage controller 100 transfers the physical address PADD corresponding to the free sub block FSB to the nonvolatile memory device 400, and the nonvolatile memory device 400 may perform the data program operation DPO (S30) to store the write data WDT in the physical address PADD corresponding to the free sub block FSB. In other words, when there is no available free sub block FSB (S15: NO) and at least one wordline of the first sub block SB1 is in the programmed state (S16: NO), the nonvolatile memory device 400 may secure the available free sub block FSB by performing the garbage collection operation GCO, and the program operation with respect to the first sub block SB1 may be replaced with the program operation with respect to the available free sub block FSB.

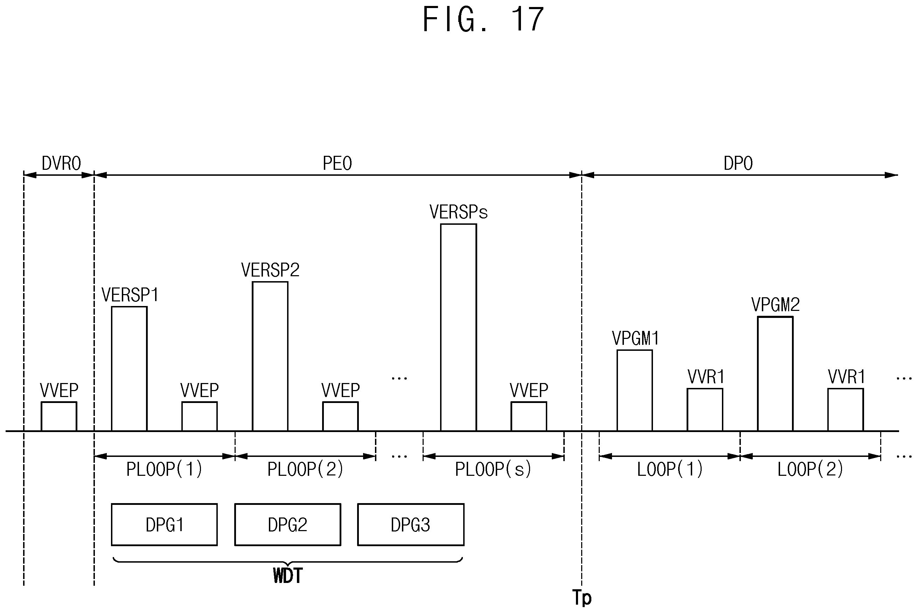

FIG. 17 is a diagram illustrating a timing of a post erase operation in a method of controlling a nonvolatile memory device according to some implementations.

Referring to FIGS. 1 and 17, the storage device 1200 receives the write data WDT including a plurality of page data DPG1, DPG2 and DPG3 from the host device 1100, and performs the state-bit mapping SBM as described with reference to FIG. 4 with respect to the received page data DPG1, DPG2 and DPG3. The mapped data generated by the state-bit mapping SBM may be transferred to the nonvolatile memory device 400, and the data program operation DPO may be performed based on the mapped data at a point in time Tp.

As shown in FIG. 17, while receiving the write data WDT from the host device 1100, the disturbance verification read operation DVRO and the post erase operation PEO as described above may be performed, that is, the disturbance verification read operation DVRO and the post erase operation PEO may be performed in parallel with the preparation process of the data program operation DPO such as transmission of the write data WDT and the state-bit mapping SBM.

The transmission of the write data WDT takes a relatively long time, and by appropriately setting the maximum number (s) of the erase loops PLOOP(1) to PLOOP(s) of the post erase operation PEO, the post erase operation PEO may be performed while receiving the WDT. Accordingly, the start point Tp of the data program operation DPO may be determined regardless of whether the post erase operation PEO is performed or omitted.

As a result, the reliability of the nonvolatile memory device may be efficiently improved without degrading the performance of the nonvolatile memory device by performing the disturbance verification read operation DVRO and the post erase operation PEO during the transmission of write data and the status-bit mapping.

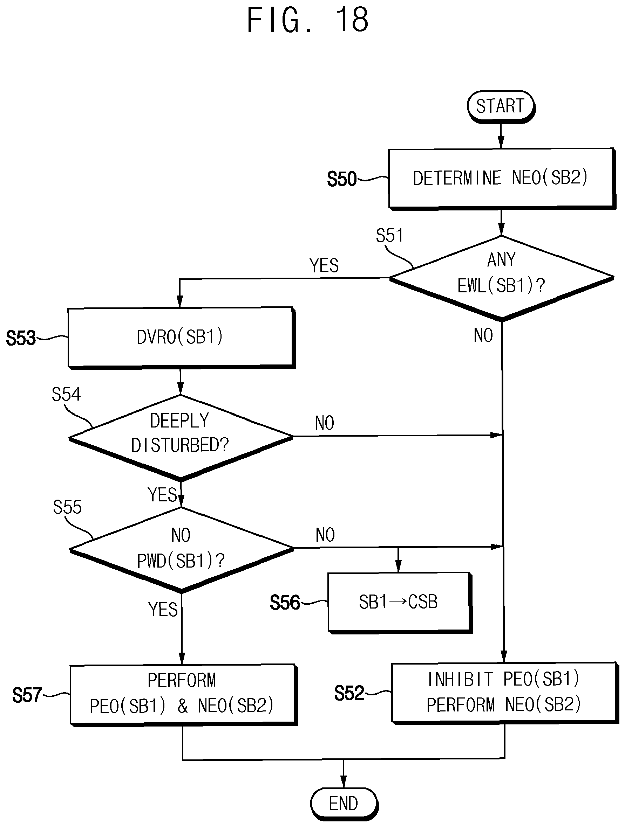

FIG. 18 is a flowchart illustrating a method of controlling a nonvolatile memory device according to some implementations.

Referring to FIGS. 1 and 18, the storage controller determines the normal erase operation NEO of the second sub block SB2 (S50). When the normal erase operation NEO for the second sub block SB2 is determined, the post erase controller 130 determine whether the first sub block SB1 belonging to the same memory block as the second sub block SB2 includes a wordline EWL in the erased state (S51).

When the first sub block SB1 does not include the wordline EWL corresponding to the erased state (S51: NO), the nonvolatile memory device 400 may inhibit the post erase operation PEO with respect to the first sub block SB1 and perform the normal erase operation NEO with respect to the second sub block SB2 (S52).

When the first sub block SB1 includes the wordline EWL corresponding to the erased state (S51: YES), the post erase controller 130 may perform the disturbance verification read operation DVRO with respect to the first sub block SB1 (S53) to determine whether the threshold voltage of the memory cells connected to the wordline in the erased state of the first sub block SB1 is increased higher than the reference level, that is, whether the first sub block SB1 is deeply disturbed. The disturbance verification read operation DVRO may be performed before performing the normal erase operation (NEO) with respect to the second sub block SB2.

When the first sub block SB1 is not deeply disturbed (S54: NO), that is, when the result of the disturbance verify read operation DVRO indicates that the threshold voltage of the memory cells connected to the wordline in the erased state of the first sub block SB1 is not increased higher than the reference level, the nonvolatile memory device 400 may inhibit the post erase operation PEO with respect to the first sub block SB1 and perform the normal erase operation NEO with respect to the second sub block SB2 (S52).

When the first sub block SB1 is deeply disturbed (S54: YES), the post erase controller 130 may determine whether all wordlines of the first sub block SB1 are in the erased state, that is, whether the first sub block SB1 includes no wordline PWL corresponding to the program state (S55).

When all wordlines of the first sub block SB1 are in the erased state (S55: YES), the nonvolatile memory device 400 may perform the normal erase operation NEO with respect to the second sub block SB2 and simultaneously perform the post erase operation PEC with respect to the first sub block SB1 (S57).

Meanwhile, when at least one wordline of the first sub block SB1 is in the programmed state (S55: NO), the nonvolatile memory device 400 may inhibit the post erase operation PEO with respect to the first sub block SB1 and perform the normal erase operation NEO with respect to the second sub block SB2 (S52). In this case, the post erase controller 130 may set the first sub block SB1 as the closed sub block CSB (S56) and inhibit programming of the first sub block SB1.

As described with reference to FIG. 18, when performing the normal erase operation NEO with respect to the second sub block SB2 corresponding to the aggressor sub block, the post erase operation PEO with respect to the first sub block corresponding to the victim sub block may be performed selectively based on the result of the disturbance verification read operation with respect to the first sub block SB1.

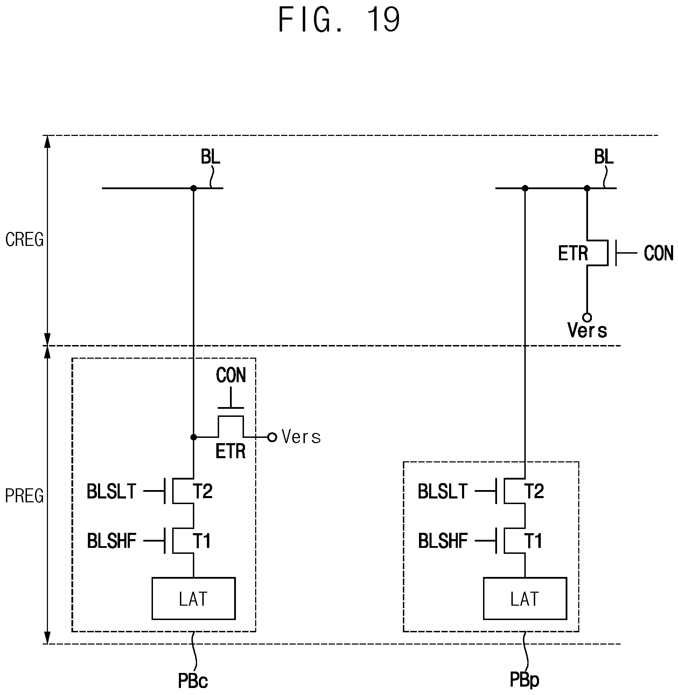

FIG. 19 is a diagram illustrating a comparative example and a nonvolatile memory device according to some implementations.

A very large number of page buffers proportional to the number of bitlines BL may be formed in the peripheral region PREG. FIG. 19 shows a page buffer PBc in a first case and a page buffer PBp in a second case included in the nonvolatile memory device.

The page buffer PBc includes a latch circuit LAT, transistors T1 and T2 controlling an electrical connection between the bitline BL and the latch circuit LAT in response to control signals BLSLT and BLSHF, and an erase transistor ETR for controlling the application of the erase voltage Vers to the bitline BL in response to a control signal CON during the erase operation.

On the other hand, the page buffer PBc does not include the erase transistor ETR, and the erase transistor ETR is formed in the cell region CREG. As will be described below, the erase transistor ETR may be implemented using an erase channel structure ECH formed in the cell region CREG.

As a result, the page buffer PBp has a smaller size than the page buffer PBc by removing the erase transistor ETR. In general, since a nonvolatile memory device includes a very large number of page buffers, the size of the nonvolatile memory device may be remarkably reduced by reducing the size of the page buffer.

As such, in the nonvolatile memory device according to some implementations, the erase transistor ETR for controlling the erase voltage Vers applied to the bitline BL may be removed from the page buffer circuit and implement the erase transistor ETR using the erase channel structure ECH, thereby reducing the size of the page buffer circuit and the nonvolatile memory device.

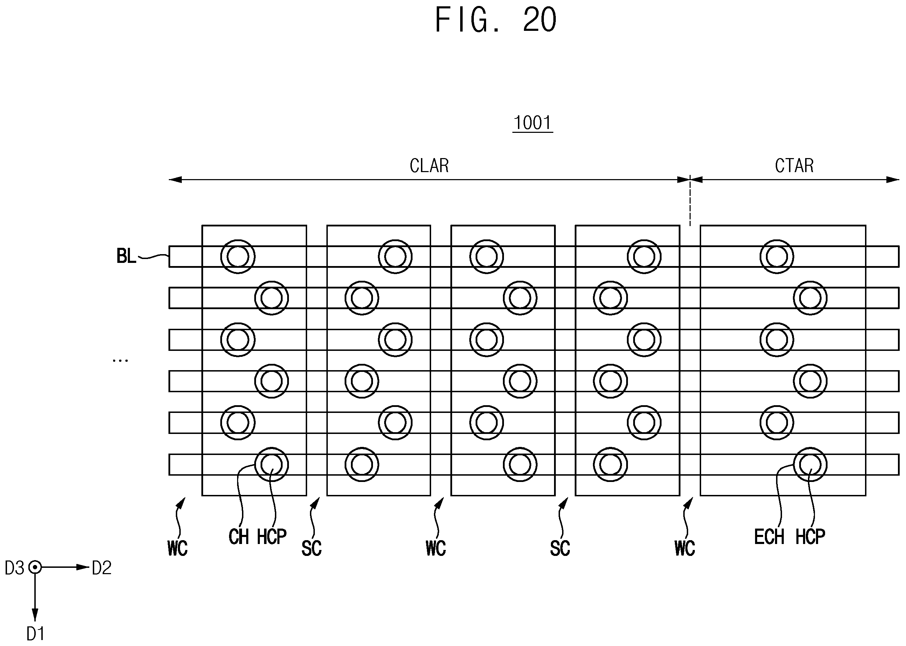

FIG. 20 is a plan view of a nonvolatile memory device according to some implementations, and FIG. 21 is a cross-sectional diagram illustrating a vertical structure of the nonvolatile memory device of FIG. 20. FIG. 22 is an enlarged sectional view illustrating an end portion of an erase channel structure included in the nonvolatile memory device of FIG. 21. FIG. 21 illustrates a vertical structure by cutting a nonvolatile memory device 1001 of FIG. 20 along a second horizontal direction D2. Hereinafter, descriptions repeated with FIG. 1 may be omitted.

Referring to FIGS. 20, 21 and 22, a gate electrode structure including gate lines or gate electrodes SSL, WL and GSL may be disposed above a semiconductor substrate SUB. The substrate SUB may include a semiconductor material, e.g., silicon, germanium, silicon-germanium, or III-V semiconductor compounds, e.g., GaP, GaAs, GaSb, etc. The gate electrode structure SSL, WL and GSL may be cut by the string selection line cut areas SC and/or the wordline cut areas WC as described above.

The gate electrode structure SSL, WL and GSL may include a buffer oxide layer 210, and gate electrodes 220 and insulating patterns 230, which are alternately and repeatedly stacked on the buffer oxide layer 210. The buffer oxide layer 210 may cover a top surface of the substrate SUB. The buffer oxide layer 210 may include, for example, a thermally-grown oxide layer or a silicon oxide layer. The gate electrodes 220 may include at least one ground selection gate electrode GSL, cell gate electrodes WL, and at least one string selection gate electrode SSL. The ground selection gate electrode GSL may be the lowermost electrode of the gate electrodes 220, and the string selection gate electrode SSL may be the uppermost electrode of the gate electrodes 220. The cell gate electrodes WL may be disposed between the ground selection gate electrode GSL and the string selection gate electrode SSL. The gate electrodes 220 may be formed of or may include at least one of, for example, doped silicon, metals (e.g., tungsten), metal nitrides, metal silicides, or any combination thereof.

The insulating patterns 230 may be disposed between the gate electrodes 220, which are placed adjacent to each other in the vertical direction D3 perpendicular to the top surface of the substrate SUB. The majority of the insulating patterns 230 may have the same thickness, and at least one of the insulating patterns 230 may be thicker than other insulating patterns. For example, an uppermost insulating pattern (hereinafter, a first insulating pattern) on the string selection gate electrode SSL may be thicker than underlying insulating patterns. The first insulating pattern may be thicker by at least two times than the underlying insulating patterns. The insulating patterns 230 may be formed of or may include, for example, silicon oxide.

The nonvolatile memory device 1001 may be divided in the vertical direction D3 into the cell region CREG and the peripheral region PREG and may be divided in the second horizontal direction D2 into the cell string area CLAR and the contact area CTAR.

The cell channel structures CH may penetrate the gate electrode structure SSL, WL and GSL. Each cell channel structure CH may include a vertical channel portion 315 and a charge storing structure 310 surrounding the vertical channel portion 315. In addition, each cell channel structure CH may include an internal space, which is formed in the vertical channel portion 315, and a gap-fill layer 320, which is surrounded by the internal space. Each cell channel structure CH may include a pad 330 provided in an upper portion thereof. The cell channel structures CH may be arranged in a zigzag shape or in a line shape, when viewed top down. The vertical channel portions 315 may be electrically connected to the substrate SUB. The vertical channel portions 315 may include a single layer or multiple layers. The vertical channel portions 315 may include at least one of, for example, a single crystalline silicon layer, an organic semiconductor layer, or carbon nanostructures.

The charge storing structures 310 may extend along outer sidewalls of the vertical channel portions 315 and in the vertical direction D3. For example, the charge storing structures 310 may have a shape surrounding the outer sidewalls of the vertical channel portions 315. The charge storing structures 310 may include at least one of, for example, a silicon oxide layer, a silicon nitride layer, a silicon oxynitride layer, and high-k dielectric layers and may have a single- or multi-layered structure.

As shown in FIG. 22, each of the charge storing structures 310 may include a tunnel insulating layer TL, a blocking insulating layer BLL, and a charge storing layer CTL. The tunnel insulating layer TL may be disposed adjacent to each of the vertical channel portions 315 to enclose or cover the outer sidewall of the vertical channel portion 315. The blocking insulating layer BLL may be disposed adjacent to the gate electrodes 220. The charge storing layer CTL may be disposed between the tunnel insulating layer TL and the blocking insulating layer BLL. The tunnel insulating layer TL may include, for example, a silicon oxide layer or a high-k dielectric layer (e.g., aluminum oxide (Al₂O₃) or hafnium oxide (HfO₂)). The blocking insulating layer BLL may include, for example, a silicon oxide layer or a high-k dielectric layer (e.g., aluminum oxide (Al₂O₃) or hafnium oxide (HfO₂)). The charge storing layer CTL may include, for example, a silicon nitride layer. The gap-fill layers 320 may include, for example, a silicon oxide layer, a silicon nitride layer, or a silicon oxynitride layer.

The pad 330 may be disposed in the upper portion of each cell channel structure CH and each erase channel structure ECH. The pad 330 may extend laterally to cover the top surface of the vertical channel portion 315 and a top surface of the charge storing structure 310. The pad 330 may cover at least one of a top surface of the tunnel insulating layer TL, a top surface of the charge storing layer CTL, and a top surface of the blocking insulating layer BLL. For example, as shown in FIG. 21, the pad 330 may cover all of the top surfaces of the tunnel insulating layer TL, the charge storing layer CTL, and the blocking insulating layer BLL. The pad 330 may include a semiconductor material that is doped with impurities of the first conductivity type. As an example, the pad 330 may be a highly doped n-type region.

The vertical channel portion 315 and the pad 330 may be formed of a semiconductor material (e.g., silicon). As an example, the vertical channel portion 315 and the pad 330 may include poly silicon. The vertical channel portion 315 and the pad 330 may have different crystallographic structures from each other.

As described above, during the erase operation, the erase voltage Vers may be applied to the bitlines BL, and, through the GIDL phenomenon, electron-hole pairs may be produced in the vertical channel portion 315. The electrons may be moved toward the pads 330 and the holes may be supplied to the vertical channel portions 315. Thus, it may be possible to effectively provide the holes into the charge storing layers CTL from the vertical channel portions 315, during the erase operation, and consequently to improve an erase operation property of the three-dimensional nonvolatile memory device.

Referring to FIGS. 21-22, a first interlayered insulating layer 460 is disposed on the gate electrode structure SSL, WL and GSL. The first interlayered insulating layer 460 may cover the top surface of the uppermost insulating pattern 230 and the top surfaces of the pads 330. The first interlayered insulating layer 460 may include, for example, a silicon oxide layer.

A second interlayered insulating layer 480 may be disposed on the first interlayered insulating layer 460. The second interlayered insulating layer 480 may cover a top surface of the first interlayered insulating layer 460. The second interlayered insulating layer 480 may include, for example, a silicon oxide layer. The channel contact plugs HCP may be disposed on each cell channel structure CH and each erase channel structure ECH. The channel contact plugs HCP may penetrate the second and first interlayered insulating layers 460 and 480 and may be in direct contact with the pads 330. The channel contact plugs HCP may include at least one of, for example, metal materials (e.g., copper or tungsten) and metal nitrides (e.g., TiN, TaN, or WIN).

The bitlines BL may be disposed on the second interlayered insulating layer 480. The bitlines BL may extend in second horizontal direction D2 in the cell string area CLAR and the contact area CTAR. The bitlines BL may be arranged to be spaced apart from each other in the first horizontal direction D1. Each bitline BL may be electrically connected to the cell channel structures CH and the erase channel structure ECH arranged along the second horizontal direction D2. The bitlines BL may include, for example, a metal material.

The charge storing structure 310 may be provided to enclose the side surface of the vertical channel portion 315 and may be interposed between the bottom surface of the vertical channel portion 315 and the substrate SUB. In other words, the vertical channel portion 315 may be separated from the substrate SUB.

A source conductive pattern SCP may be disposed between the substrate SUB and the buffer oxide layer 210. The source conductive pattern SCP may include a first source conductive pattern SCP1 and a second source conductive pattern SCP2. The second source conductive pattern SCP2 may be disposed on a top surface of the first source conductive pattern SCP1. The first source conductive pattern SCP1 may be extended from a region between the substrate SUB and the second source conductive pattern SCP2 to other regions between the second source conductive pattern SCP2 and the vertical channel portion 315 and between the substrate SUB and the vertical channel portion 315. As illustrated in FIG. 22, due to the first source conductive pattern SCP1, the charge storing structure 310 may be divided into an upper charge storing structure 310a, which is placed on the first source conductive pattern SCP1, and a lower charge storing structure 310b, which is placed below the first source conductive pattern SCP1.

In some example implementations, the first source conductive pattern SCP1 includes a horizontal portion PP and a vertical portion VP. The horizontal portion PP of the first source conductive pattern SCP1 may be disposed between the substrate SUB and the second source conductive pattern SCP2. The vertical portion VP may be extended from a region between the vertical channel portion 315 and the horizontal portion PP to other regions between the second source conductive pattern SCP2 and the vertical channel portion 315 and between the substrate SUB and the vertical channel portion 315. The vertical portion VP may be in contact with the charge storing structure 310. A top surface of the vertical portion VP may be located at a vertical level between a top surface of the horizontal portion PP and a top surface of the second source conductive pattern SCP2. A bottom surface of the vertical portion VP may be located at a lower vertical level than the top surface of the substrate SUB. The first and second source conductive patterns SCP1 and SCP2 may be formed of a polysilicon layer, which is doped with impurities of the first conductivity type, and a concentration of impurities doped into the second source conductive pattern SCP2 may be higher than that in the first source conductive pattern SCP1. Such source conductive pattern SCP may be used as the source line CSL.

According to some implementations, the erase channel structures ECH are formed in the contact area CTAR that is adjacent to the cell string area CLAR in the second horizontal direction D2. The erase channel structures ECH are connected between the bitlines BL and the source line CSL. The erase channel structures ECH include the erase transistors ETR, respectively. The erase selection line EGSL is formed in the contact area CTAR to form the gate electrodes of the erase transistors ETR in the erase channel structures ECH.

In some example implementations, as illustrated in FIGS. 20 and 21, one erase channel structure ECH is connected to one bitline BL.

In some example implementations, as illustrated in FIG. 21, the source line CSL extends uninterrupted (without cutting) in the second horizontal direction D2 through the cell string area CLAR and to the contact area CTAR. With this configuration, the source line CSL may be commonly connected to the cell channel structures CH and the erase channel structures ECH. Accordingly, the erase voltage Vers applied to the source line CSL may be applied to the bottom portions of the cell channel structures CH and simultaneously applied to the upper portions of the cell channel structures CH through the erase channel structures ECH and the bitlines BL.

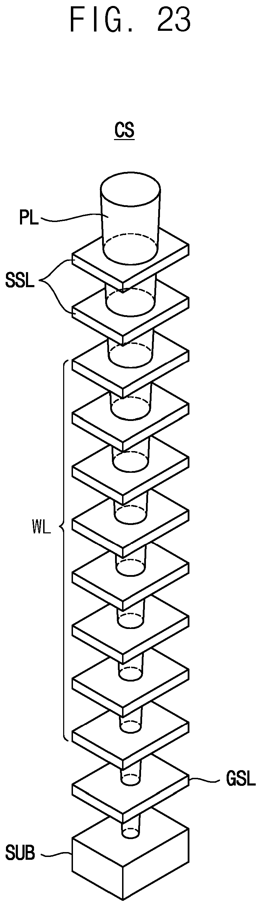

FIG. 23 is a diagram illustrating an example structure of a cell string included in a nonvolatile memory device according to some implementations.

Referring to FIG. 23, to form a cell string CS, a pillar PL extending in a direction perpendicular to the surface of substrate SUB and contacting the substrate SUB is provided on the substrate SUB. The ground selection line GSL, wordlines WL, and string selection lines SSL may be formed of conductive materials parallel to the substrate SUB, for example, metal materials. The pillar PL may contact the substrate SUB by passing through conductive materials forming the ground selection line GSL, the wordlines WL, and the string selection lines SSL. Also, the wordlines WL may include dummy wordlines not used for data storage. A dummy wordline may be used for a variety of purposes.

For example, in the manufacturing process of the cell string CS, the width of the pillar PL or the cross-sectional area parallel to the upper surface of the substrate SUB may be formed smaller as the distance to the substrate SUB decreases. Therefore, when the same voltage is applied to the bodies of the ground selectin transistor GST, the memory cells MCs, and the string selection transistors SSTs, the electric field formed in the memory cell adjacent to the substrate SUB or the ground selection transistor GST may be greater than the electric field formed in the memory cell or string selection transistor SST far from the substrate SUB. These characteristics affect program disturbances that occur while the program operations are being performed. However, the width of the pillar PL or the cross-sectional area parallel to the upper surface of the substrate SUB is not limited thereto. The width of the pillar PL or the cross-sectional area parallel to the upper surface of the substrate SUB may be formed differently according to the distance from the substrate SUB depending on the etching process.

As such, characteristics of memory cells may be different according to positions of wordlines. Considering these characteristics, at least one wordline to be subjected to the above-described disturbance verification read operation DVRO may be set.

FIG. 24 is a perspective view illustrating a memory block included in a nonvolatile memory device according to some implementations.

In FIG. 24, memory cells are omitted and gate lines stacked in the vertical direction D3 are illustrated for convenience of illustration. The gate lines may include string selection lines SSL1~SSL4, wordlines WL, intermediate switching lines MSL1 and MSL2 and ground selection lines GSL1 and GSL2. The first intermediate switching line MSL1 and the first ground selection line GSL1 correspond to a first string group and the second intermediate switching line MSL2 and the second ground selection line GSL2 correspond to a second string group.

Referring to FIG. 24, a memory block including a plurality of cell strings is divided into a plurality of sub blocks SB1 and SB2. The intermediate switching lines MSL1 and MSL2 and intermediate switching transistors controlled by the intermediate switching lines MSL1 and MSL2 may be formed in a boundary layer BND between the sub blocks SB1 and SB2.

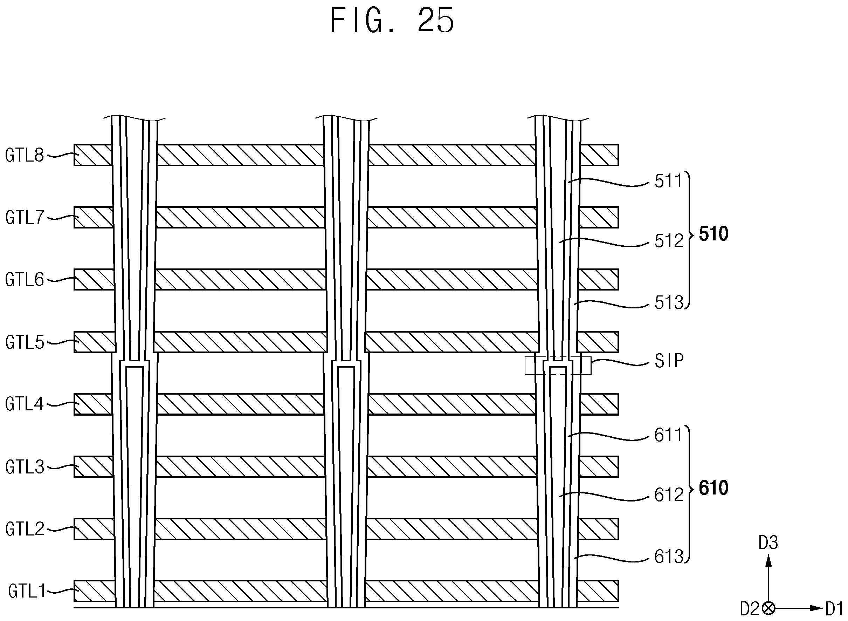

FIG. 25 is a cross-sectional view for describing some implementations of a boundary layer included in the memory block of FIG. 24.

Referring to FIG. 25, a channel hole of each cell string STR includes a first sub channel hole 610 and a second sub channel hole 510. A channel hole may be referred to as a pillar. The first sub channel hole 610 may include a channel layer 611, an inner material 612 and an insulation layer 613. The second sub channel hole 510 may include a channel layer 511, an inner material 512 and an insulation layer 513. The channel layer 611 of the first channel hole 610 may be connected to the channel layer 511 of the second sub channel hole 510 through a P-type silicon pad SIP. The sub channel holes 610 and 510 may be formed using a stopper line GTL5 having an appropriate etch rate. For example, the stopper line GTL5 may be formed of polysilicon and the other gate lines GTL1~GTL4 and the GTL6~GTL8 may be formed of metal such as tungsten to implement the appropriate etch rate.

The boundary layer BND between the sub blocks SB1 and SB2 in FIG. 24 may correspond to the stopper layer GTL5 that is used to form the plurality of sub channel holes. The cells in the stopper layer GTL5 may be improper for storing data, and the stopper layer GTL5 may be used as the boundary layer BND to form the intermediate switching transistors.

Hereinafter, example implementations of selectively switching a plurality of intermediate switching transistors by units of string groups based on an erase address and a direction in which an erase voltage is applied are described with reference to FIGS. 26A through 30B.

FIGS. 26A through 30B are diagrams illustrating a method of performing an erase operation in a nonvolatile memory device according to some implementations.

Referring to FIGS. 26A, 27A, 28A, 29A and 30A, a memory block of a nonvolatile memory device includes a plurality of cell strings STR1~STR4 and each of the cell strings STR1~STR4 may include a plurality of memory cells that are disposed in the vertical direction D3. The memory block may be divided into a first sub block SB1 and a second sub block by a boundary layer BND.

FIGS. 26A through 27B illustrate example implementations that the erase voltage VERS is applied through the common source line CSL of the memory block.

FIGS. 26A through 27B show implementations in which an erase voltage VERS is applied through a common source line. Referring to FIGS. 26A through 27B, the erase voltage VERS is applied to the common source line CSL of the plurality of cell strings STR1~STR4 for an erase operation. The ground selection transistors may be turned on by applying the turn-on voltage VGON to the ground selection line GSL while the erase voltage VERS is applied to the common source line CSL. All string selection transistors may be turned off by applying the turn-off voltage VSOFF to the string selection line SSL.

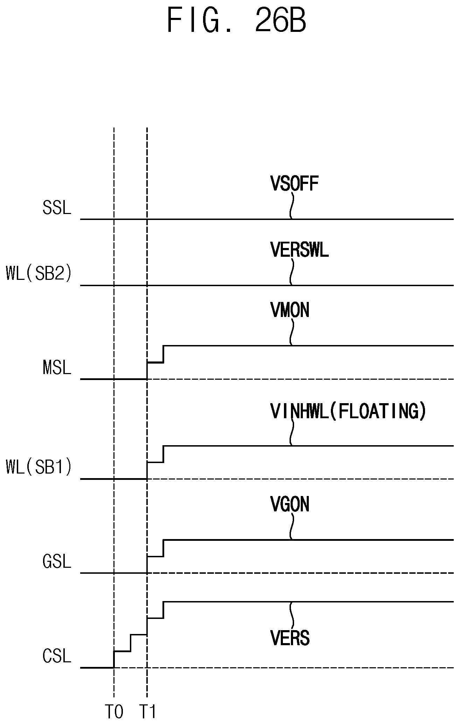

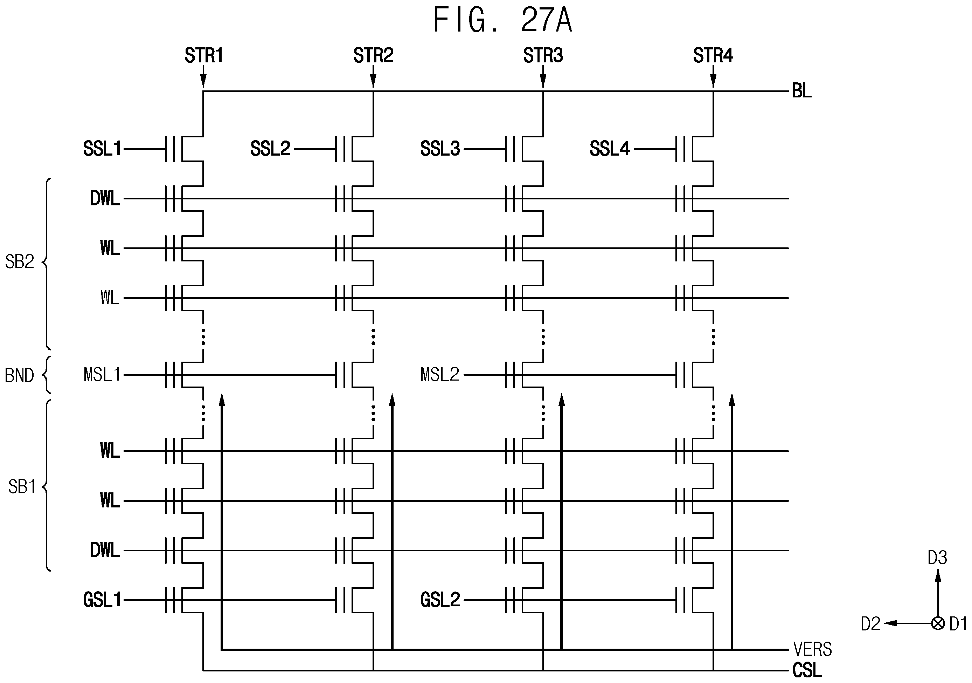

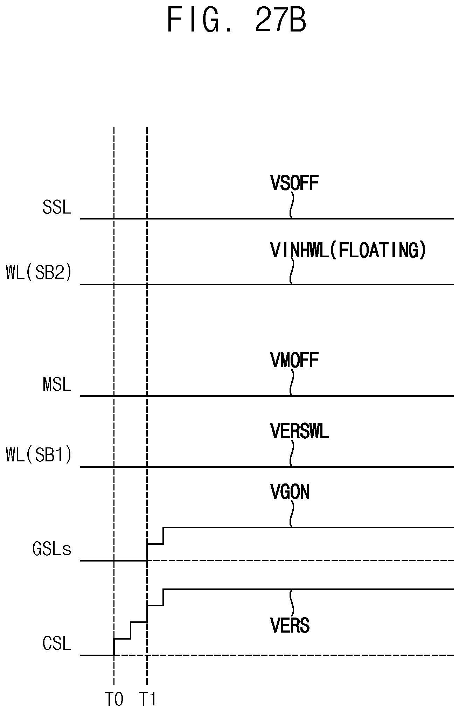

As illustrated in FIGS. 26A and 26B, when the erase voltage VERS is applied to the common source line CSL and the second sub block SB2 is erased, the intermediate switching transistors may be turned on by applying the turn-on voltage VMON to the intermediate switching line MSL. Meanwhile, as shown in FIGS. 27A and 27B, when the erase voltage VERS is applied to the common source line CSL and the first sub block SB1 is erased, the intermediate switching transistors may be turned off by applying the turn-off voltage to the intermediate switching line MSL.

The erase permission voltage VERSWL may be applied to wordlines of sub blocks to be erased, and the erase inhibition voltage VINHWL may be applied to the wordlines of sub blocks not to be erased.

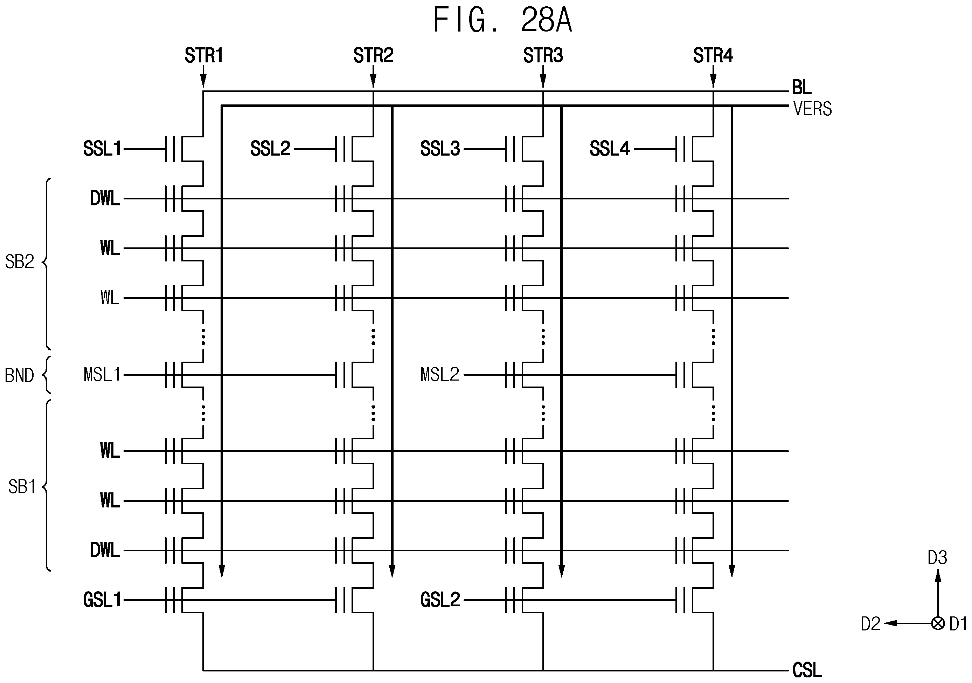

FIGS. 28A through 29B show implementations in which the erase voltage VERS is applied through a bitline. Referring to FIGS. 28A through 29B, the erase voltage VERS is applied to the bitlines BL of the plurality of cell strings STR1~STR4 for the erase operation. The string selection transistors may be turned on by applying the turn-on voltage VSON to the string selection line SSL while applying the erase voltage VERS to the bitlines BL.

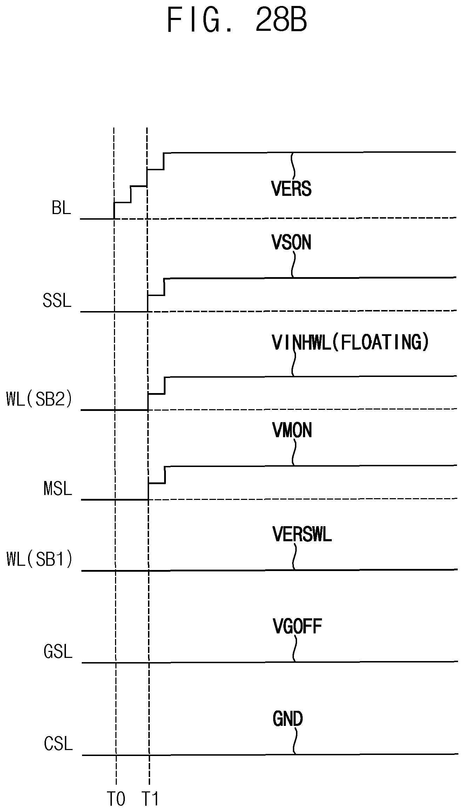

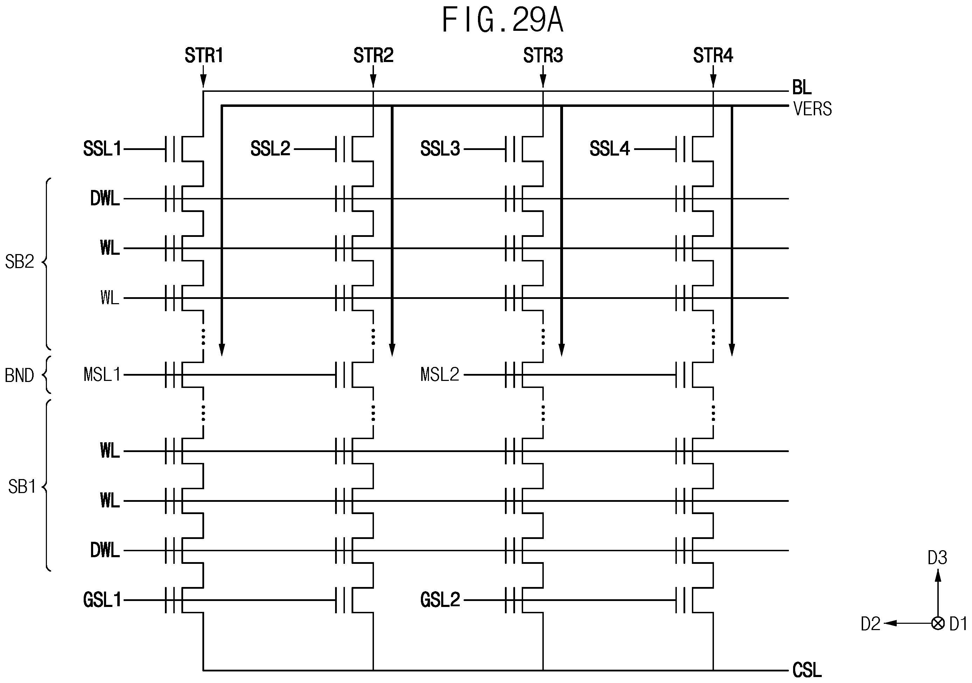

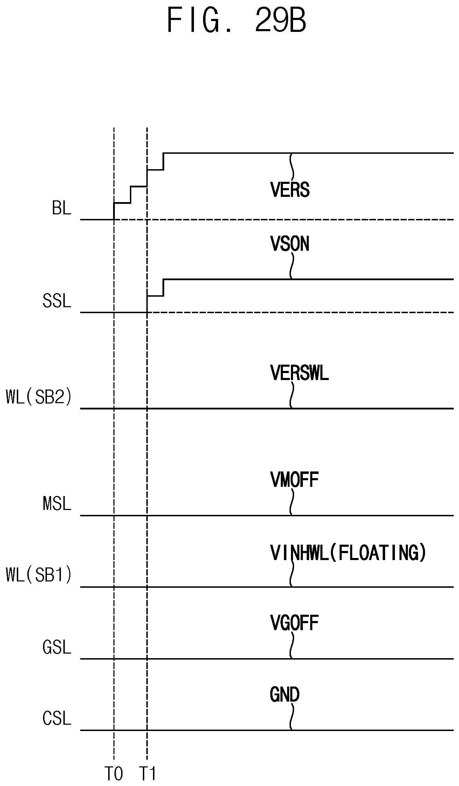

As illustrated in FIGS. 28A and 28B, when the erase voltage VERS is applied to the bitlines BL and the first sub block SB1 is erased, the intermediate switching transistors are turned on by applying the turn-on voltage VMON to the intermediate switching line MSL. Meanwhile, as shown in FIGS. 29A and 29B, when the erase voltage VERS is applied to the bitlines BL and the second sub block SB2 is erased, the intermediate switching transistors are turned off by applying the turn-off voltage VMOFF to the intermediate switching line MSL.

The erase permission voltage VERSWL may be applied to wordlines of sub blocks to be erased, and the erase inhibition voltage VINHWL may be applied to wordlines of sub blocks not to be erased. The turn-off voltage VGOFF may be applied to the ground selection line GSL, and the ground voltage GND may be applied to the common source line CSL.

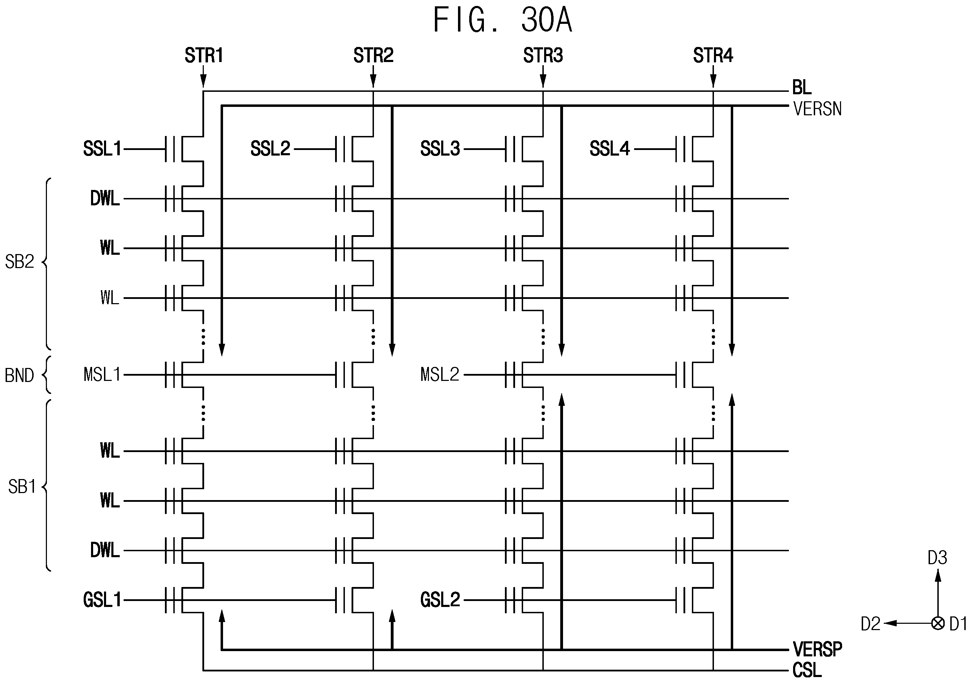

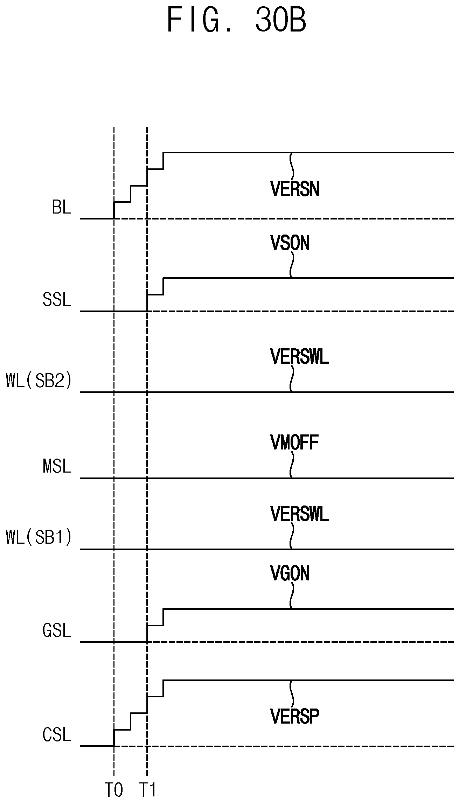

FIGS. 30A and 30B show implementations in which the erase voltage VERS is applied through a common source line and a bitline.

The first sub block SB1 and the second sub block SB2 may be simultaneously erased by applying the erase voltage VERS to the common source line CSL and the bitlines BL. In this case, for example, by applying the normal erase voltage VERSN to the bitlines BL and applying the post erase voltage VERSP to the common source line CSL, the normal erase operation NEO may be performed with respect to the sub block SB2 and simultaneously the post erase operation PEO may be performed with respect to the first sub block SB as described with reference to FIG. 18. In this case, all of the intermediate switching transistors may be turned off by applying the turn-off voltage VMOFF to the intermediate switching line MSL.

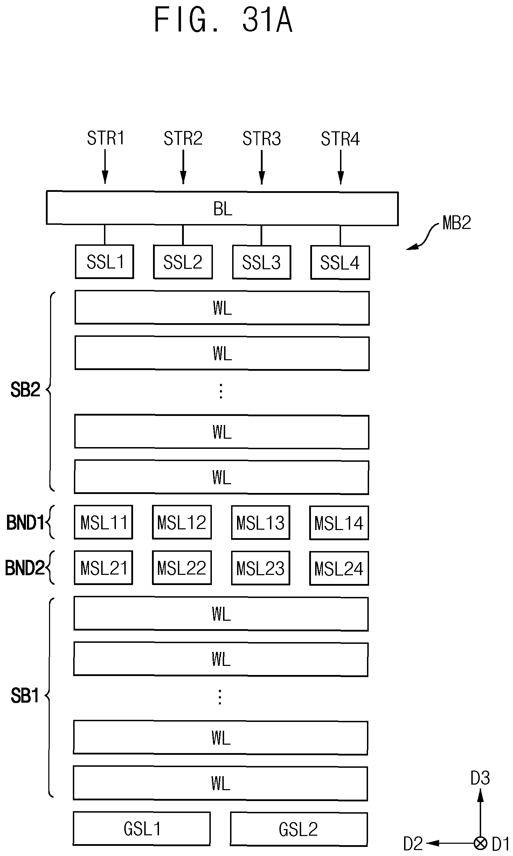

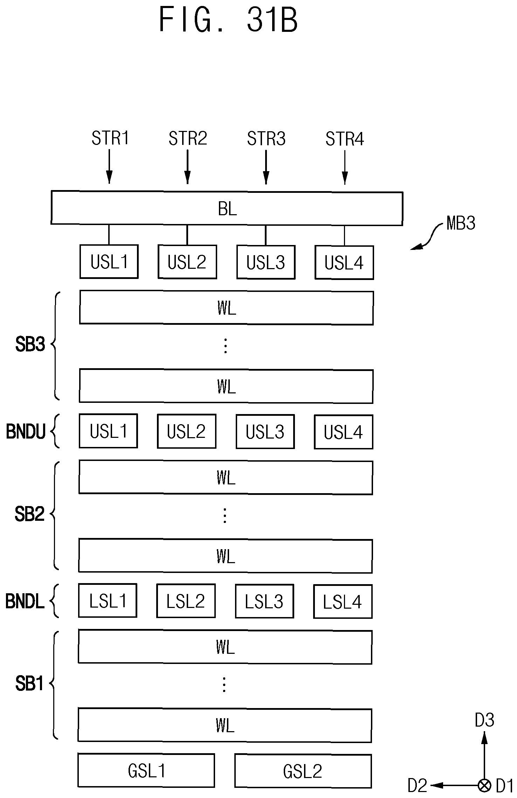

FIGS. 31A and 31B are cross-sectional views illustrating a memory block included in a nonvolatile memory device according to some implementations. Memory blocks in FIGS. 31A and 31B are similar to the memory block as described with reference to FIGS. 24 and 25, and the repeated descriptions may be omitted.

Referring to FIG. 31A, the boundary layers BND1 and BND2 of the memory block MB2 include two or more gate layers adjacent to each other in the vertical direction D3. FIG. 31A shows two adjacent gate layers, that is, a first boundary layer BND1 and a second boundary layer BND2 adjacent in the vertical direction D3, but are not limited thereto. According to some implementations, three or more gate layers adjacent in the vertical direction D3 may be provided as the boundary layers.

The first boundary layer BND1 may include a plurality of intermediate switching lines MSL11~MSL14 respectively controlling the electrical connection of the plurality of cell strings STR1~STR4, and the second boundary layer BND2 may include a plurality of intermediate switching lines MSL21~MSL24 respectively controlling the electrical connection of the cell strings STR1~STR4. The same driving voltage may be commonly applied to the two intermediate switching lines MSL1i and MSL2i (i=1, 2, 3, 4) belonging to the same cell string STRi.

Referring to FIG. 31B, the memory block MB3 includes a lower boundary layer BNDL and an upper boundary layer BNDU. The memory block MB3 includes a first sub block SB1 disposed under the lower boundary layer BNDL, a second sub block SB2 disposed between the lower boundary layer BNDL and the upper boundary layer BNDU, and a third sub block SB3 disposed above the upper boundary layer BNDU.

The above-described intermediate switching transistors may include a plurality of lower switching transistors disposed on the lower boundary layer BNDL and connected to the lower switching lines LSL1~LSL4, and a plurality of upper switching transistors disposed on the upper boundary layer BNDU and connected to the upper switching lines ULS1~USL4.

Hereinafter, a manufacturing process of a nonvolatile memory device according to some implementations of the present invention will be briefly described.

Each integrated circuit may be formed on a first wafer WF1 and a second wafer WF2. The above-described memory cell array may be formed on the first wafer WF1, and peripheral circuits may be formed on the second wafer WF2. In other words, the first wafer WF1 may correspond to the aforementioned cell region CREG, and the second wafer WF2 may correspond to the aforementioned peripheral region PREG. A plurality of first bonding metal patterns may be formed on a bottom surface of the first wafer WF1, and a plurality of second bonding metal patterns may be formed on an upper surface of the second wafer WF2 .

In a state in which the integrated circuits of the first wafer WF1 and the second wafer WF2 are formed, the first wafer WF1 and the second wafer WF2 may be bonded by a bonding method. In this case, the plurality of first bonding metal patterns and the plurality of second bonding metal patterns may be connected to each other such that the cell region CREG and the peripheral region PREG may be connected in the vertical direction.

The bonded wafers WF1 and WF2 are cut into a plurality of chips, and each chip corresponds to a semiconductor device including stacked semiconductor dies. The cut portion of the first wafer WF1 corresponds to the first semiconductor die and the cut portion of the second waiter WF2 corresponds to the second semiconductor die.

As described above, the nonvolatile memory device and the method of controlling the nonvolatile memory device according to some implementations may reduce unnecessary erasure of memory cells and increase the lifespan of the nonvolatile memory device by grouping the memory block into the sub blocks to manage the erase operation. In addition, the nonvolatile memory device and the method of controlling the nonvolatile memory device according to some implementations may secure the reliability of the nonvolatile memory device and enhance the performance of the nonvolatile memory device by reducing the disturbance caused in the victim sub block by the aggressor sub block through the post erase operation.

The inventive concept according to the appended claims may be applied to any electronic devices and systems. For example, the inventive concept according to the appended claims may be applied to systems such as a memory card, a solid state drive (SSD), an embedded multimedia card (eMMC), a universal flash storage (UFS), a mobile phone, a smart phone, a personal digital assistant (PDA), a portable multimedia player (PMP), a digital camera, a camcorder, a personal computer (PC), a server computer, a workstation, a laptop computer, a digital TV, a set-top box, a portable game console, a navigation system, a wearable device, an internet of things (IoT) device, an internet of everything (IoE) device, an e-book, a virtual reality (VR) device, an augmented reality (AR) device, a server system, an automotive driving system, etc.

While this disclosure contains many specific implementation details, these should not be construed as limitations on the scope of what may be claimed. Certain features that are described in this disclosure in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations and even initially be claimed as such, one or more features from a combination can in some cases be excised from the combination, and the combination may be directed to a subcombination or variation of a subcombination.

## Claims

1. A method of controlling a nonvolatile memory device (400), comprising:
dividing (S100) a memory block into a plurality of sub blocks including a first sub block and a second sub block that are disposed in a vertical direction (D3) where the memory block includes a plurality of cell strings (STR1~STR4) and each cell string includes a plurality of memory cells that are disposed in the vertical direction (D3);
performing (S200) a normal erase operation (NEO) independently with respect to each of the plurality of sub blocks;
performing (S300) a disturbance verification read operation (DVRO) with respect to the first sub block to determine whether a threshold voltage (VTH) of memory cells connected to a wordline in an erased state of the first sub block is increased higher than a reference level by a program operation and a read operation with respect to the second sub block; and
selectively performing (S400) a post erase operation (PEO) based on a result of the disturbance verification read operation (DVRO) to decrease the threshold voltage (VTH) of memory cells in the erased state of the first sub block, wherein
performing the disturbance verification read operation (DVRO) includes:
applying a post erase verification voltage (VVEP) to the wordline in the erased state of the first sub block such that the post erase verification voltage (VVEP) is higher than a normal erase verification voltage (VVEN) of the normal erase operation (NEO).

2. The method of claim 1, wherein the first sub block and the second sub block share a same channel (CH).

3. The method of claim 1, wherein selectively performing the post erase operation (PEO) includes:
applying a post erase voltage (VERSP1, VERSP2) to channels (CHs) of the first sub block such that the post erase voltage (VERSP1, VERSP2) is lower than a normal erase voltage (VERSN1, VERSN2) of the normal erase operation (NEO).

4. The method of claim 3, wherein the normal erase operation (NEO) and the post erase operation (PEO) are performed by an incremental step pulse erasing (ISPE) scheme, and
wherein the post erase voltage (VERSP1, VERSP2) of a first erase loop (PLOOP(1)) of the post erase operation (PEO) is lower than the normal erase voltage (VERSN1, VERSN2) of a first erase loop (PLOOP(1)) of the normal erase operation (NEO).

5. The method of claim 1, wherein the disturbance verification read operation (DVRO) with respect to the first sub block is performed before a program operation (DPO) with respect to the first sub block is performed.

6. The method of claim 5, further comprising:
subsequent to determining that the result of the disturbance verification read operation (DVRO) indicates that the threshold voltage (VTH) of the memory cells connected to the wordline in the erased state of the first sub block is increased higher than the reference level, determining whether an available free sub block (FSB) in the erased state exists.

7. The method of claim 6, wherein, subsequent to determining that the available free block exists, the program operation (DPO) with respect to the first sub block is replaced with the program operation with respect to the available free sub block (FSB) and programming with respect to the first sub block is inhibited.

8. The method of claim 7, wherein the post erase operation (PEO) with respect to the first sub block is performed as a background operation, and
wherein, after the post erase operation (PEO) with respect to the first sub block is completed, the first sub block is set as a free sub block (FSB) such that programming with respect to the first sub block is permitted.

9. The method of claim 6, wherein, subsequent to determining that the available free sub block (FSB) does not exist and all wordlines of the first sub block are in the erased state, the program operation (DPO) with respect to the first sub block is performed after the post erase operation (PEO) with respect to the first sub block is completed.

10. The method of claim 6, wherein, subsequent to determining that the available free sub block (FSB) does not exist and at least one wordline of the first sub block is in a programmed state, the available free sub block (FSB) is generated by performing a garbage collection operation (GCO) and the program operation (DPO) with respect to the first sub block is replaced with the program operation with respect to the available free sub block (FSB).

11. The method of claim 5, wherein, subsequent to determining that the result of the disturbance verification read operation (DVRO) indicates that the threshold voltage (VTH) of the memory cells connected to the wordline in the erased state of the first sub block is not increased higher than the reference level, the post erase operation (PEO) with respect to the first sub block is omitted and the program operation (DPO) with respect to the first sub block is performed.

12. The method of claim 11, wherein the disturbance verification read operation (DVRO) and the post erase operation (PEO) are performed while the nonvolatile memory device (400) receives write data for the program operation from a host device (1100).

13. The method of claim 1, wherein the disturbance verification read operation (DVRO) with respect to the first sub block is performed before the normal erase operation (NEO) with respect to the second sub block is performed.

14. A nonvolatile memory device (400) comprising:
a memory cell array including a memory block, the memory block being divided into a plurality of sub blocks including a first sub block and a second sub block that are disposed in a vertical direction (D3) where the memory block includes a plurality of cell strings (STR1~STR4) and each cell string includes a plurality of memory cells that are disposed in the vertical direction (D3); and
a control circuit (850) configured to
perform a normal erase operation (NEO) independently with respect to each of the plurality of sub blocks,
perform a disturbance verification read operation (DVRO) with respect to the first sub block to determine whether a threshold voltage (VTH) of memory cells connected to a wordline in an erased state of the first sub block is increased higher than a reference level by a program operation and a read operation with respect to the second sub block, and
selectively perform a post erase operation (PEO) based on a result of the disturbance verification read operation (DVRO) to decrease the threshold voltage (VTH) of memory cells in the erased state of the first sub block, wherein
performing the disturbance verification read operation (DVRO) includes:
applying a post erase verification voltage (VVEP) to the wordline in the erased state of the first sub block such that the post erase verification voltage (VVEP) is higher than a normal erase verification voltage (VVEN) of the normal erase operation (NEO).

15. The nonvolatile memory device (400) of claim 14 further comprising:
a plurality of first bonding metal patterns disposed in a cell region (CREG), a plurality of second bonding metal patterns disposed in a peripheral region (PREG) disposed under the cell region (CREG), wherein the peripheral region (PREG) is vertically coupled to the cell region (CREG) by the plurality of first bonding metal patterns and the plurality of second bonding metal patterns, wherein
the memory cell array is disposed in the cell region (CREG), and
the control circuit (850) is disposed in the peripheral region (PREG).

## Patentansprüche

1. Verfahren zum Steuern einer nichtflüchtigen Speichervorrichtung (400), aufweisend:
Unterteilen (S100) eines Speicherblocks in eine Mehrzahl von Sub-Blöcken, die einen ersten Sub-Block und einen zweiten Sub-Block beinhalten, die in einer vertikalen Richtung (D3) angeordnet sind, wobei der Speicherblock eine Mehrzahl von Zellenfolgen (STR1~STR4) umfasst und jede Zellenfolge eine Mehrzahl von Speicherzellen umfasst, die in der vertikalen Richtung (D3) angeordnet sind;
unabhängiges Durchführen (S200) einer normalen Löschoperation (NEO) in Bezug auf jeden von der Mehrzahl von Sub-Blöcken;
Durchführen (S300) einer Störungsverifizierungs-Leseoperation (DVRO) in Bezug auf den ersten Sub-Block, um festzustellen, ob eine Schwellenspannung (VTH) von Speicherzellen, die mit einer Wortleitung verbunden sind, in einem gelöschten Zustand des ersten Sub-Blocks durch eine Programmieroperation und eine Leseoperation in Bezug auf den zweiten Sub-Block über einen Referenzpegel hinaus erhöht worden ist; und
selektives Durchführen (S400) einer Nachlöschoperation (PEO) basierend auf einem Ergebnis der Störungsverifizierungs-Leseoperation (DVRO), um die Schwellenspannung (VTH) der Speicherzellen in dem gelöschten Zustand des ersten Sub-Blocks zu verringern, wobei
das Durchführen der Störungsverifizierungs-Leseoperation (DVRO) umfasst:
Anlegen einer Nachlösch-Verifizierungsspannung (VVEP) an die Wortleitung in dem gelöschten Zustand des ersten Sub-Blocks, sodass die Nachlösch-Verifizierungsspannung (VVEP) höher ist als eine normale Lösch-Verifizierungsspannung (VVEN) der normalen Löschoperation (NEO).

2. Verfahren nach Anspruch 1, wobei der erste Sub-Block und der zweite Sub-Block denselben Kanal (CH) gemeinsam nutzen.

3. Verfahren nach Anspruch 1, wobei das selektive Durchführen der Nachlöschoperation (PEO) umfasst:
Anlegen einer Nachlöschspannung (VERSP1, VERSP2) an Kanäle (CHs) des ersten Sub-Blocks, derart, dass die Nachlöschspannung (VERSP1, VERSP2) niedriger ist als eine normale Löschspannung (VERSN1, VERSN2) der normalen Löschoperation (NEO).

4. Verfahren nach Anspruch 3, wobei die normale Löschoperation (NEO) und die Nachlöschoperation (PEO) durch ein Inkrementalschrittimpuls-Löschverfahren (ISPE) durchgeführt werden, und
wobei die Nachlöschspannung (VERSP1, VERSP2) einer ersten Löschschleife (PLOOP(1)) der Nachlöschoperation (PEO) niedriger ist als die normale Löschspannung (VERSN1, VERSN2) einer ersten Löschschleife (PLOOP(1)) der normalen Löschoperation (NEO).

5. Verfahren nach Anspruch 1, wobei die Störungsverifizierungs-Leseoperation (DVRO) in Bezug auf den ersten Sub-Block durchgeführt wird, bevor eine Programmieroperation (DPO) in Bezug auf den ersten Sub-Block durchgeführt wird.

6. Verfahren nach Anspruch 5, ferner umfassend:
nachdem festgestellt wurde, dass das Ergebnis der Störungsverifizierungs-Leseoperation (DVRO) anzeigt, dass die Schwellenspannung (VTH) der mit der Wortleitung verbundenen Speicherzellen in dem gelöschten Zustand des ersten Sub-Blocks über den Referenzpegel hinaus angestiegen ist, Bestimmen, ob ein verfügbarer freier Sub-Block (FSB) in dem gelöschten Zustand vorhanden ist.

7. Verfahren nach Anspruch 6, wobei, nachdem festgestellt wurde, dass der verfügbare freie Block vorhanden ist, die Programmieroperation (DPO) in Bezug auf den ersten Sub-Block durch die Programmieroperation in Bezug auf den verfügbaren freien Sub-Block (FSB) ersetzt wird und ein Programmieren in Bezug auf den ersten Sub-Block verhindert wird.

8. Verfahren nach Anspruch 7, wobei die Nachlöschoperation (PEO) in Bezug auf den ersten Sub-Block als eine Hintergrundoperation durchgeführt wird, und
wobei, nachdem die Nachlöschoperation (PEO) in Bezug auf den ersten Sub-Block beendet worden ist, der erste Sub-Block als einer freier Sub-Block (FSB) gesetzt wird, sodass ein Programmieren in Bezug auf den ersten Sub-Block zugelassen wird.

9. Verfahren nach Anspruch 6, wobei, nachdem festgestellt wurde, dass der verfügbare freie Sub-Block (FSB) nicht vorhanden ist und sich alle Wortleitungen des ersten Sub-Blocks im gelöschten Zustand befinden, die Programmieroperation (DPO) in Bezug auf den ersten Sub-Block durchgeführt wird, nachdem die Nachlöschoperation (PEO) in Bezug auf den ersten Sub-Block beendet worden ist.

10. Verfahren nach Anspruch 6, wobei, nachdem festgestellt wurde, dass der verfügbare freie Sub-Block (FSB) nicht vorhanden ist und sich mindestens eine Wortleitung des ersten Sub-Blocks in einem programmierten Zustand befindet, der verfügbare freie Sub-Block (FSB) durch Durchführen einer Garbage-Collection-Operation (GCO) erzeugt wird und die Programmieroperation (DPO) in Bezug auf den ersten Sub-Block durch die Programmieroperation in Bezug auf den verfügbaren freien Sub-Block (FSB) ersetzt wird.

11. Verfahren nach Anspruch 5, wobei, nachdem festgestellt wurde, dass das Ergebnis der Störungsverifizierungs-Leseoperation (DVRO) anzeigt, dass die Schwellenspannung (VTH) der mit der Wortleitung verbundenen Speicherzellen im gelöschten Zustand des ersten Sub-Blocks nicht über den Referenzpegel hinaus ansteigt, die Nachlöschoperation (PEO) in Bezug auf den ersten Sub-Block ausgelassen und die Programmieroperation (DPO) in Bezug auf den ersten Sub-Block durchgeführt wird.

12. Verfahren nach Anspruch 11, wobei die Störungsverifizierungs-Leseoperation (DVRO) und die Nachlöschoperation (PEO) durchgeführt werden, während die nichtflüchtige Speichervorrichtung (400) Schreibdaten für die Programmieroperation von einer Host-Vorrichtung (1100) empfängt.

13. Verfahren nach Anspruch 1, wobei die Störungsverifizierungs-Leseoperation (DVRO) in Bezug auf den ersten Sub-Block durchgeführt wird, bevor die normale Löschoperation (NEO) in Bezug auf den zweiten Sub-Block durchgeführt wird.

14. Nichtflüchtige Speichervorrichtung (400), aufweisend:
eine Speicherzellenanordnung, die einen Speicherblock umfasst, wobei der Speicherblock in eine Mehrzahl von Sub-Blöcken unterteilt ist, welche einen ersten Sub-Block und einen zweiten Sub-Block beinhalten, die in einer vertikalen Richtung (D3) angeordnet sind,
wobei der Speicherblock eine Mehrzahl von Zellenfolgen (STR1~STR4) umfasst und jede Zellenfolge eine Mehrzahl von Speicherzellen umfasst, die in der vertikalen Richtung (D3) angeordnet sind; und
eine Steuerschaltung (850), die so konfiguriert ist, dass sie
eine normale Löschoperation (NEO) in Bezug auf jeden von der Mehrzahl von Sub-Blöcken unabhängig durchführt,
eine Störungsverifizierungs-Leseoperation (DVRO) in Bezug auf den ersten Sub-Block durchführt, um festzustellen, ob eine Schwellenspannung (VTH) der Speicherzellen, die mit einer Wortleitung verbunden sind, in einem gelöschten Zustand des ersten Sub-Blocks durch eine Programmieroperation und eine Leseoperation in Bezug auf den zweiten Sub-Block über einen Referenzpegel hinaus erhöht wurde, und
eine Nachlöschoperation (PEO) basierend auf einem Ergebnis der Störungsverifizierungs-Leseoperation (DVRO) selektiv durchführt, um die Schwellenspannung (VTH) von Speicherzellen im gelöschten Zustand des ersten Sub-Blocks zu verringern, wobei
die Durchführung der Störungsverifizierungs- Leseoperation (DVRO) umfasst:
Anlegen einer Nachlösch-Verifizierungsspannung (VVEP) an die Wortleitung im gelöschten Zustand des ersten Sub-Blocks, derart, dass die Nachlösch-Verifizierungsspannung (VVEP) höher ist als eine normale Lösch-Verifizierungsspannung (VVEN) der normalen Löschoperation (NEO).

15. Nichtflüchtige Speichervorrichtung (400) nach Anspruch 14, ferner aufweisend:
eine Mehrzahl von ersten Bondingmetallmustern, die in einem Zellbereich (CREG) angeordnet sind, eine Mehrzahl von zweiten Bondingmetallmustern, die in einem unterhalb des Zellbereichs (CREG) angeordneten Peripheriebereich (PREG) angeordnet sind, wobei der Peripheriebereich (PREG) durch die Mehrzahl von ersten Bondingmetallmustern und die Mehrzahl von zweiten Bondingmetallmustern vertikal mit dem Zellbereich (CREG) gekoppelt ist, wobei
die Speicherzellenanordnung in dem Zellbereich (CREG) angeordnet ist und
die Steuerschaltung (850) in dem Peripheriebereich (PREG) angeordnet ist.

## Revendications

1. Procédé de commande d'un dispositif de mémoire non volatile (400), comprenant :
diviser (S100) un bloc de mémoire en une pluralité de sous-blocs incluant un premier sous-bloc et un deuxième sous-bloc qui sont disposés dans une direction verticale (D3), le bloc de mémoire incluant une pluralité de chaînes de cellules (STR1~STR4) et chaque chaîne de cellules incluant une pluralité de cellules de mémoire qui sont disposées dans la direction verticale (D3) ;
effectuer (S200) une opération d'effacement normal (NEO) indépendamment pour chacun des sous-blocs de la pluralité de sous-blocs ;
effectuer (S300) une opération de lecture de vérification de perturbation (DVRO) sur le premier sous-bloc afin de déterminer si une tension de seuil (VTH) de cellules de mémoire connectées à une ligne de mots du premier sous-bloc à l'état effacé est augmentée au-dessus d'un niveau de référence par une opération de programmation et une opération de lecture sur le deuxième sous-bloc ; et
effectuer sélectivement (S400) une opération de post-effacement (PEO) sur la base d'un résultat de l'opération de lecture de vérification de perturbation (DVRO) afin de diminuer la tension de seuil (VTH) de cellules de mémoire dans l'état effacé du premier sous-bloc, dans lequel
l'exécution de l'opération de lecture de vérification de perturbation (DVRO) inclut :
appliquer une tension de vérification de post-effacement (VVEP) à la ligne de mots dans l'état effacé du premier sous-bloc de telle sorte que la tension de vérification de post-effacement (VVEP) est supérieure à une tension de vérification d'effacement normal (VVEN) de l'opération d'effacement normal (NEO).

2. Procédé selon la revendication 1, dans lequel le premier sous-bloc et le deuxième sous-bloc partagent un même canal (CH).

3. Procédé selon la revendication 1, dans lequel l'exécution sélective de l'opération de post-effacement (PEO) inclut :
appliquer une tension de post-effacement (VERSP1, VERSP2) à des canaux (CHs) du premier sous-bloc de telle sorte que la tension de post-effacement (VERSP1, VERSP2) est inférieure à une tension d'effacement normal (VERSN1, VERSN2) de l'opération d'effacement normal (NEO).

4. Procédé selon la revendication 3, dans lequel l'opération d'effacement normal (NEO) et l'opération de post-effacement (PEO) sont effectuées selon un schéma d'effacement par impulsions à pas incrémentiel (ISPE), et
dans lequel la tension de post-effacement (VERSP1, VERSP2) d'une première boucle d'effacement (PLOOP(1)) de l'opération de post-effacement (PEO) est inférieure à la tension d'effacement normal (VERSN1, VERSN2) d'une première boucle d'effacement (PLOOP(1)) de l'opération d'effacement normal (NEO).

5. Procédé selon la revendication 1, dans lequel l'opération de lecture de vérification de perturbation (DVRO) sur le premier sous-bloc est effectuée avant qu'une opération de programmation (DPO) sur le premier sous-bloc ne soit effectuée.

6. Procédé selon la revendication 5, comprenant en outre :
après avoir déterminé que le résultat de l'opération de lecture de vérification de perturbation (DVRO) indique que la tension de seuil (VTH) des cellules de mémoire connectées à la ligne de mots dans l'état effacé du premier sous-bloc est augmentée au-dessus du niveau de référence, déterminer s'il existe un sous-bloc libre disponible (FSB) dans l'état effacé.

7. Procédé selon la revendication 6, dans lequel, après avoir déterminé que le sous-bloc libre disponible existe, l'opération de programmation (DPO) sur le premier sous-bloc est remplacée par l'opération de programmation sur le sous-bloc libre disponible (FSB) et une programmation sur le premier sous-bloc est inhibée.

8. Procédé selon la revendication 7, dans lequel l'opération de post-effacement (PEO) sur le premier sous-bloc est effectuée en tant qu'opération d'arrière-plan, et
dans lequel, après achèvement de l'opération de post-effacement (PEO) sur le premier sous-bloc, le premier sous-bloc est défini en tant que sous-bloc libre (FSB) de telle sorte qu'une programmation sur le premier sous-bloc est autorisée.

9. Procédé selon la revendication 6, dans lequel, après avoir déterminé que le sous-bloc libre disponible (FSB) n'existe pas et que toutes les lignes de mots du premier sous-bloc sont dans l'état effacé, l'opération de programmation (DPO) sur le premier sous-bloc est effectuée après achèvement de l'opération de post-effacement (PEO) sur le premier sous-bloc.

10. Procédé selon la revendication 6, dans lequel, après avoir déterminé que le sous-bloc libre disponible (FSB) n'existe pas et qu'au moins une ligne de mots du premier sous-bloc est dans un état programmé, le sous-bloc libre disponible (FSB) est généré en effectuant une opération de ramasse-miettes (GCO) et l'opération de programmation (DPO) sur le premier sous-bloc est remplacée par l'opération de programmation sur le sous-bloc libre disponible (FSB).

11. Procédé selon la revendication 5, dans lequel, après avoir déterminé que le résultat de l'opération de lecture de vérification de perturbation (DVRO) indique que la tension de seuil (VTH) des cellules de mémoire connectées à la ligne de mots dans l'état effacé du premier sous-bloc n'est pas augmentée au-dessus du niveau de référence, l'opération de post-effacement (PEO) sur le premier sous-bloc est omise et l'opération de programmation (DPO) sur le premier sous-bloc est effectuée.

12. Procédé selon la revendication 11, dans lequel l'opération de lecture de vérification de perturbation (DVRO) et l'opération de post-effacement (PEO) sont effectuées tandis que le dispositif de mémoire non volatile (400) reçoit, depuis un dispositif hôte (1100), des données d'écriture pour l'opération de programmation.

13. Procédé selon la revendication 1, dans lequel l'opération de lecture de vérification de perturbation (DVRO) sur le premier sous-bloc est effectuée avant que l'opération d'effacement normal (NEO) sur le deuxième sous-bloc ne soit effectuée.

14. Dispositif de mémoire non volatile (400) comprenant :
une matrice de cellules de mémoire incluant un bloc de mémoire, le bloc de mémoire étant divisé en une pluralité de sous-blocs incluant un premier sous-bloc et un deuxième sous-bloc qui sont disposés dans une direction verticale (D3), le bloc de mémoire incluant une pluralité de chaînes de cellules (STR1~STR4) et chaque chaîne de cellules incluant une pluralité de cellules de mémoire qui sont disposées dans la direction verticale (D3) ; et
un circuit de commande (850) configuré pour
effectuer une opération d'effacement normal (NEO) indépendamment pour chacun des sous-blocs de la pluralité de sous-blocs,
effectuer une opération de lecture de vérification de perturbation (DVRO) sur le premier sous-bloc afin de déterminer si une tension de seuil (VTH) de cellules de mémoire connectées à une ligne de mots du premier sous-bloc à l'état effacé est augmentée au-dessus d'un niveau de référence par une opération de programmation et une opération de lecture sur le deuxième sous-bloc, et
effectuer sélectivement une opération de post-effacement (PEO) sur la base d'un résultat de l'opération de lecture de vérification de perturbation (DVRO) afin de diminuer la tension de seuil (VTH) de cellules de mémoire dans l'état effacé du premier sous-bloc, dans lequel
l'exécution de l'opération de lecture de vérification de perturbation (DVRO) inclut :
appliquer une tension de vérification de post-effacement (VVEP) à la ligne de mots dans l'état effacé du premier sous-bloc de telle sorte que la tension de vérification de post-effacement (VVEP) est supérieure à une tension de vérification d'effacement normal (VVEN) de l'opération d'effacement normal (NEO).

15. Dispositif de mémoire non volatile (400) selon la revendication 14, comprenant en outre :
une pluralité de premiers motifs métalliques de liaison disposés dans une région de cellules (CREG), une pluralité de deuxièmes motifs métalliques de liaison disposés dans une région périphérique (PREG) disposée sous la région de cellules (CREG), dans lequel la région périphérique (PREG) est couplée verticalement à la région de cellules (CREG) par la pluralité de premiers motifs métalliques de liaison et la pluralité de deuxièmes motifs métalliques de liaison, dans lequel
la matrice de cellules de mémoire est disposée dans la région de cellules (CREG), et
le circuit de commande (850) est disposé dans la région périphérique (PREG).
